Europäisches Patentamt

European Patent Office

Office européen des brevets

(19)

(11) EP 0 989 593 A2

(12) EUROPEAN PATENT APPLICATION

(43) Date of publication:
29.03.2000 Bulletin 2000/13

(51) Int Cl.⁷: H01L 21/00, H01L 21/20

(21) Application number: 99307446.7

(22) Date of filing: 21.09.1999

(84) Designated Contracting States:
AT BE CH CY DE DK ES FI FR GB GR IE IT LI LU
MC NL PT SE
Designated Extension States:
AL LT LV MK RO SI

(30) Priority: 25.09.1998 JP 27215798
16.10.1998 JP 29593498
26.08.1999 JP 24014099

(71) Applicant: CANON KABUSHIKI KAISHA
Tokyo (JP)

(72) Inventors:
• Ohmi, Kazuaki
Ohta-ku, Tokyo (JP)

• Yonehara, Takao
Ohta-ku, Tokyo (JP)
• Sakaguchi, Kiyofumi
Ohta-ku, Tokyo (JP)
• Yanagita, Kazutaka
Ohta-ku, Tokyo (JP)

(74) Representative:
Beresford, Keith Denis Lewis et al
BERESFORD & Co.
High Holborn
2-5 Warwick Court
London WC1R 5DJ (GB)

(54) **Substrate separating apparatus and method, and substrate manufacturing method**

(57)    This invention provides a bonded substrate stack separating apparatus. A bonded substrate stack (101) is sandwiched and supported from both sides by a pair of substrate supporting members (201, 202) each having an annular shape. An enclosed space (210) is formed around a porous layer (101b) exposed to the edge of the bonded substrate stack (101). A fluid is injected into the enclosed space (210), and pressure is applied to the fluid. The pressure of the fluid substantially standing still is applied to the porous layer (101b) to separate the bonded substrate stack (101) at the porous layer (101b). This invention also provides a separating method suitable to separate a bonded substrate stack. A bonded substrate stack (100) formed by bonding a first substrate (10) having a cavity-containing layer (e.g., a porous layer formed by anodizing) (2) on a main body substrate (1) and, on the cavity-containing layer, a non-cavity-containing layer (e.g., a single-crystal Si layer and an insulating layer) (3) to a second substrate (20) is stored in a closed vessel, and pressure is applied. Cavity walls (2a, 2c) break due to the pressure difference between the external pressure and the internal pressure in cavities (2b, 2d) in the cavity-containing layer (2). Break progresses into the cavity-containing layer (2), so the bonded substrate stack (100) is separated at the cavity-containing layer (2).

FIG. 10

EP 0 989 593 A2

## Description

## BACKGROUND OF THE INVENTION

### FIELD OF THE INVENTION

The present invention relates to a sample separating apparatus and method and a substrate manufacturing method and, more particularly, to a separating method and apparatus for separating a sample having a separation layer at this separation layer, and a semiconductor substrate manufacturing method using the separating method, and a separating method and apparatus for separating a sample having a cavity-containing layer with a number of cavities at the cavity-containing layer, and a substrate manufacturing method using the separating method.

### DESCRIPTION OF THE RELATED ART

A substrate (SOI substrate) having an SOI (Silicon On Insulator) structure is known as a substrate having a single-crystal Si layer on an insulating layer. A device using this SOI substrate has many advantages that cannot be achieved by ordinary Si substrates. Examples of the advantages are as follows.

(1) The integration degree can be increased because dielectric isolation is easy.
(2) The radiation resistance can be increased.
(3) The operating speed of the device can be increased because the stray capacitance is small.
(4) No well step is necessary.
(5) Latch-up can be prevented.
(6) A completely depleted field-effect transistor can be formed by thin film formation.

These are described in detail in "Special Issue: "Single-crystal silicon on non-single-crystal insulators"; edited by G.W. Cullen, Journal of Crystal Growth, volume 63, No. 3, pp. 429 - 590 (1983)".

According to many recent reports, a SOI substrate is effective to realize a high-speed and low-power-consumption MOSFET (IEEE SOI conference 1994). When an SOI structure is employed, the element isolation process can be simplified as compared to a structure having an element formed on a bulk Si substrate because of the presence of the insulating layer under the element. Hence, the device process can be shortened. More specifically, not only a device with higher performance but also reduction of overall cost including wafer cost and process cost is expected by employing the SOI substrate.

Especially, an FD (Fully Depleted) MOSFET is expected to achieve high speed and low power consumption due to improved drivability. Generally, the threshold voltage (Vth) of a MOSFET is determined by the impurity concentration in the channel portion. However, the threshold voltage of an FD MOSFET using a SOI substrate also depends on the thickness of the depletion layer. The thickness of the depletion layer is influenced by the thickness of the SOI layer. Hence, to manufacture large-scale integrated circuits at a high yield, the thickness of an SOI layer must be uniformed.

A device formed on a compound semiconductor substrate has high performance (e.g., operation speed or light emission properties) that cannot be obtained by a device formed on a normal Si substrate. Conventionally, such a device is formed in a layer epitaxially grown on a compound semiconductor substrate such as a GaAs substrate. A compound semiconductor substrate is expensive and poor in mechanical strength. In addition, the area is difficult to increase. An epitaxial layer formed by this method is poor in crystallinity due to a difference in lattice constant or thermal expansion coefficient. For this reason, it is very hard to apply this layer to a device. To relax lattice mismatching, a method of epitaxially growing a compound semiconductor on porous Si has been examined. However, the stability and reliability of the substrate during or after device formation are low in this method because of the low thermal stability and change-over-time in porous Si. An examination has been made to heteroepitaxially grow a compound semiconductor on an inexpensive Si substrate which has a high mechanical strength and is easy to increase in its area.

From 1970s, extensive studies have been made about formation of an SOI substrate. In the early days, a technique of heteroepitaxially growing single-crystal Si on a sapphire substrate as an insulator (SOS: Sapphire On Silicon), a technique of forming an SOI structure by dielectric isolation by oxidizing porous Si (FIPOS: Fully Isolation by Porous Oxidized Silicon), or oxygen ion implantation was mainly studied.

In FIPOS, an island-shaped n-type Si layer is formed on the surface of a p-type single-crystal Si substrate by proton ion implantation (Imai et al., J. Crystal Growth, vol. 63,547 (1983)) or epitaxial growth and patterning. The resultant structure is anodized from its surface in an HF solution to form a porous structure in only the p-type substrate such that the porous structure surrounds the n-type Si island. After this, the n-type Si island is dielectric-isolated by accelerated oxidation. With this technique, the Si region to be isolated is determined before the device process. Hence, the degree of freedom in device design must be limited.

Oxidation ion implantation is reported by K. Izumi for the first time and also called SIMOX. In this technique, oxygen ions are implanted into an Si substrate at a dose of about $10^{17}$ to $10^{18}/cm^2$, and the resultant structure is annealed in an argon/oxygen atmosphere at a high temperature of about $1,320°C$. As a result, oxygen ions implanted to a depth corresponding to the projection range (Rp) of ion implantation bond Si to form an Si oxide layer. Upon annealing, an Si layer at the upper portion of the Si oxide layer, which is converted into an amorphous layer by oxygen ion implantation, re-crystallizes to form a single-crystal Si layer. Defects contained in the Si layer on the surface are conventionally as many as about $10^5/cm^2$. When the oxygen implantation dose is about $4 \times 10^{17}/cm^2$, the number of defects can be reduced to $10^2/cm^2$ or less. However, since the range of implantation energy or implantation dose for maintaining the film quality of the Si oxide layer or the crystallinity of the surface Si layer high is narrow, the film thickness of the surface Si layer or buried Si oxide layer (BOX: Buried oxide) is limited to a specific value. To obtain a surface Si layer with a desired film thickness, sacrifice oxidation or epitaxial growth is necessary. In this case, since degradation due to the process is superposed on the film thickness distribution, the uniformity of film thickness degrades.

Reportedly, a BOX has a region called a "pipe" where an Si oxide layer formation failure is present. A probable cause for this is a foreign substance such as dust in implantation. The device characteristics degrade at a portion having a pipe due to leakage between the active layer and the support substrate.

In ion implantation by SIMOX, since the ion implantation dose is larger than that used in the conventional semiconductor process, a long implantation time is still required even when a dedicated ion implantation apparatus is developed. Ions are implanted by raster-scanning an ion beam having a predetermined current value or increasing the ion beam size. For this reason, as the substrate to be formed becomes large, the implantation time is expected to become long. Additionally, as is pointed out, when a substrate with a large area is processed at a high temperature, a slip due to the temperature distribution in the substrate readily occurs. In SIMOX, as described above, a process at a temperature as high as 1,320°C is necessary, that is not used in the conventional Si semiconductor process. For this reason, a solution to this problem is essential as well as development of apparatuses.

In recent years, a new SOI substrate manufacturing method has been developed. In this method, a single-crystal Si substrate is bonded to another single-crystal Si substrate having a thermally oxidized surface by annealing or using an adhesive, thereby forming an SOI structure (bonding). For this method, the thickness of an active layer for forming a device must be uniformly reduced. More specifically, the thickness of a single-crystal Si substrate as thick as several hundred μm must be reduced to the μm order or less. To form a thin film, polishing, local plasma etching, or selective etching can be used.

However, with thin film formation by polishing, a uniform thin film can hardly be formed. Particularly, a thin film with a thickness on the order of submicrons has variations of several ten %, and this non-uniformity poses a large problem. When the substrate size increases, this difficulty becomes more conspicuous.

In thin film formation by local plasma etching, the thickness of a single-crystal Si substrate is reduced to about 1 to 3 μm by polishing, and then, the film thickness is measured at many points on the entire surface of the substrate, thereby measuring the film thickness distribution. After this, on the basis of the measured film thickness distribution, a plasma having a diameter of several mm and using $SF_6$ is scanned to etch the substrate while correcting the film thickness distribution whereby the thickness of the single-crystal Si substrate is reduced to a desired thickness. However, if a foreign substance (particle) is present on the substrate during plasma etching, this foreign substance may act as an etching mask to form a projection on the substrate.

Immediately after plasma etching, the substrate surface is rough. To correct this, touch polishing is necessary. However, as pointed out, since the polishing amount is controlled by time management, the final film thickness is difficult to control, and the film thickness distribution degrades due to polishing. Additionally, since the abrasive such as colloidal silica directly rubs against the surface as a prospective active layer, a fracture layer may form or process distortion may occur upon polishing. When the substrate has a large size, the plasma etching time increases accordingly, and the throughput may largely decrease.

In thin film formation by selective etching, a structure allowing selective etching is formed in advance in a substrate to be thinned, and an unnecessary portion of the single-crystal Si substrate is selectively etched using this structure. In this method, for example, a p-type Si thin film containing boron at a concentration of $10^{19}/cm^3$ or more and a p-type Si thin film are formed on a p-type substrate by epitaxial growth or the like to form a first substrate. The first substrate is bonded to a second substrate while sandwiching an insulating layer such as an oxide film therebetween. The lower surface of the first substrate is ground and polished to thin it in advance. After this, the thin p-type Si layer is selectively etched to expose the p-type Si layer. The p-type Si layer is also selectively etched to expose the p-type Si layer, thereby obtaining an SOI structure. This method is described in detail in the report by Maszara (W.P. Maszara, J. Electrochem. Soc., vol. 138, 341 (1991)).

Thin film formation by selective etching is effective to uniform thin film formation. However, the obtained selectivity ratio is insufficient; it is as low as about $10^2$. In addition, since surface flatness after etching is not good, touch polishing must be performed after etching. Touch polishing readily decreases the film thickness and makes the film thickness nonuniform. Particularly, polishing is managed in relation to the etching time, though the polishing amount is difficult to control because of the large variation in polishing rate. This especially poses a serious problem in forming an SOI layer as thin as 100 nm.

In thin film formation using selective etching, epitaxial or heteroepitaxial growth is used to form an SOI layer on a $p^+$-type Si layer prepared by ion implantation.

For this reason, the crystallinity of the SOI layer is poor. In addition, the surface flatness of the surface to be bonded to the second substrate is lower than that of a conventional Si substrate (C. Harendt, et al., J. Elect. Mater. Vol. 20, 267 (1991), H. Baumgart, et al., Extended Abstract of ECS 1st International Symposium of Wafer Bonding, p. 733 (1991), C.E. Hunt, Extended Abstract of ECS 1st International Symposium of Wafer Bonding, p. 696 (1991)).

The selectivity ratio of selective etching largely depends on the concentration difference between impurities such as boron and the steepness of the impurity distribution in the direction of depth. Hence, when high-temperature bonding annealing for increasing bonding strength or high-temperature epitaxial growth for improving crystallinity is executed, the distribution width of the impurity concentration in the direction of depth increases to lower the etching selectivity. That is, improvement of the selectivity ratio of etching and improvement of crystallinity and bonding strength can hardly be simultaneously achieved.

Recently, Yonehara et al. have reported an SOI substrate manufacturing method excellent in film thickness uniformity and crystallinity and capable of a batch process (T. Yonehara et al., Appln. Phys. Lett. vol. 64, 2108 (1994)). In this method, a porous layer is formed on a single-crystal Si substrate, and a non-porous single-crystal Si layer is epitaxially grown on the porous layer. After this, this first substrate is bonded to a second substrate via an Si oxide layer. The first substrate is thinned by, e.g., grinding it from the lower surface side to expose the porous Si layer. The exposed porous Si layer is etched using a selective etchant such as KOH or a mixed solution of HF and $H_2O_2$ and removed. The selectivity ratio of etching of porous Si to bulk Si (non-porous single-crystal Si) is sufficiently high (approximately $10^5$).

Hence, an SOI substrate having a non-porous single-crystal Si layer on a second substrate can be formed without largely reducing the thickness of the non-porous single-crystal Si layer grown on the porous Si layer in advance. That is, the film thickness uniformity of the SOI layer is substantially determined in the epitaxial growth process. For the epitaxial growth process, a CVD apparatus often used in the conventional semiconductor process can be employed. According to the report by Sato et al. (SSDM95), the film thickness of an SOI layer formed by the above method achieves a uniformity of 100 nm± 2%. The crystallinity of the SOI layer is also good and achieves $3.5 \times 10^2/cm^2$.

In the conventional SOI substrate manufacturing method, the etching selectivity depends on the concentration difference between impurities and the distribution of the impurity concentration in the direction of depth. For this reason, the temperature of a heat treatment (bonding, epitaxial growth, oxidation, or the like) that causes an increase in distribution width of an impurity in the direction of depth is limited to about 800°C or less. In the method reported by Yonehara et al., the selectivity ratio of etching is determined by the structural difference between the porous Si layer and bulk Si. Hence, the limitation on the temperature of a heat treatment is small, and reportedly, a heat treatment at, e.g., about 1,180°C is possible. As is known, the heat treatment after the first and second substrates are bonded increases the bonding strength between the substrates and reduces the number of voids in the bonding interface or the size of a void. In selective etching using such structural difference, a foreign substance sticking to the porous Si layer has minimum influence on the film thickness uniformity of the finally formed SOI layer.

An Si layer formed on a transparent substrate represented by a glass substrate is generally an amorphous layer or a polycrystalline layer at the best. This is because the formed Si layer reflects the disorder of the crystal structure (amorphous) of the transparent substrate. When an Si layer is simply deposited on a transparent substrate, no satisfactory single-crystal Si layer can be obtained. The SOI substrate manufacturing method reported by Yonehara et al. is excellent in this point. That is, according to this method, a high-quality single-crystal Si layer can be formed on a transparent substrate.

The transparent substrate is important in forming, e.g., a contact sensor as a light-receiving element or a projection-type liquid crystal image display device. To obtain higher-density, higher-resolution, and higher-precision pixels (picture elements) for a contact sensor or a projection-type liquid crystal image display device, a high-performance driving element is required. It is important to form an element on the transparent substrate using a single-crystal layer having good crystallinity. When a substrate having a single-crystal layer on a transparent substrate is employed, a peripheral circuit for driving an element forming a pixel or a circuit for image processing can be formed on the same substrate as that of the element. This reduces the chip size and increases the processing speed.

The SOI substrate manufacturing method reported by Yonehara et al. is very useful and applications thereof are also expected. However, this method has an economical problem because two substrates are necessary to form a semiconductor substrate by bonding them. As a solution to this problem, Sakaguchi et al. has proposed a method of reusing the first substrate (Japanese Patent Application NO. 7-045441). In this method, instead of grounding or etching to thin the lower surface of the first substrate to expose the porous Si layer after first and second substrates are bonded, a bonded substrate stack is formed by bonding first and second substrates. The bonded substrate stack is divided at the porous layer. After this, the porous Si layer remaining on the surface on the second substrate side is selectively removed to form an SOI substrate.

To divide the bonded substrate stack at the porous layer, the following methods can be used.

(1) A tensile force or press force is applied to the entire surface of the bonded substrate stack in a direction perpendicular to the surface (in the axial direction).

(2) The porous Si layer is exposed to the side surface portion of the bonded substrate stack and etched to some extent, and a razor's-edge-like member is inserted into the etched portion.

(3) The porous Si layer is exposed to the side surface portion of the bonded substrate stack. After a liquid such as water is allowed to soak into the porous Si layer, the bonded substrate stack is heated or cooled to divide the bonded substrate stack using expansion of the soaked liquid.

(4) A force is applied to the first or second substrate of the bonded substrate stack in the planar direction.

The above division methods are based on the fact that the mechanical strength (the mechanical strength changes depending on the porosity) of the porous Si layer is much lower than that of bulk Si. More specifically, when a press, tensile, or shearing force is applied to the bonded substrate stack, the porous Si layer selectively breaks to divide the bonded substrate stack. At a high porosity, the porous layer can be broken at a weaker force to divide the bonded substrate stack.

Porous Si was found in 1956 by Uhlir et al. who were studying electropolishing of semiconductors (A. Uhlir, Bell Syst. Tech. J., vol. 35, 333 (1956)). Porous Si can be formed by anodizing an Si substrate in an HF solution. Unagami et al. studied the dissolution reaction of Si upon anodizing and reported that holes were necessary for anodizing reaction of Si in an HF solution, and the reaction was as follows (T. Unagami, J. Electrochem. Soc., vol. 127, 476 (1980)).

$$Si + 2HF + (2 - n)e^- \rightarrow SiF_2 + 2H^+ + ne^-$$

$$SiF_2 + 2HF \rightarrow SiF_4 + H_2$$

$$SiF_4 + 2HF \rightarrow H_2SiF_6$$

or

$$Si + 4HF + (4 - \lambda)e^- \rightarrow SiF_4 + 4H^+ + \lambda e^-$$

$$SiF_4 + 2HF \rightarrow H_2SiF_6$$

where $e^+$ and $e^-$ represent a hole and an electron, respectively, and n and $\lambda$ are the number of holes necessary to dissolve one Si atom. According to them, when $n > 2$ or $\lambda > 4$, porous Si is formed.

The above fact suggests that p-type Si having holes is converted into porous Si while n-type Si having no holes is not converted. The selectivity in this conversion has been reported by Nagano et at. and Imai ("Nagano, Nakajima, Anno, Onaka, and Kajiwara, IEICE Technical Report, vol. 79, SSD79-9549 (1979)", "K. Imai, Solid-State Electronics, vol. 24, 159 (1981)"). Even n-type Si can be converted into porous Si by, e.g., irradiating the n-type Si with light to generate holes.

For the method wherein the first and second substrates are bonded to form a bonded substrate stack, and the bonded substrate stack is separated into two substrates at the porous layer to form an SOI substrate, a demand has arisen for another method capable of efficient separation.

SUMMARY OF THE INVENTION

The present invention has been made in consideration of the above situation, and has as its object to provide an apparatus and method suitable for separating a sample such as a bonded substrate stack.

According to the first aspect of the present invention, there is provided a separating apparatus for separating a sample having a separation layer at the separation layer, characterized by comprising a pressure application mechanism for applying a pressure of a fluid substantially standing still at least part of the separation layer to separate the sample at the separation layer.

In the separating apparatus according to the first aspect of the present invention, preferably, the separation layer, e.g., extends across in the sample and is exposed to an edge of the sample, and the pressure application mechanism, e.g., applies the pressure of the fluid to the separation layer from at least part of the edge of the sample.

In the separating apparatus according to the first aspect of the present invention, for example, the pressure application mechanism preferably has an enclosed space forming member for surrounding at least part of a peripheral portion of the sample to form an enclosed space and applies a pressure higher than that of an external space to the enclosed space.

In the separating apparatus according to the first aspect of the present invention, for example, the enclosed space forming member preferably has a structure which allows the sample to expand near a central portion due to the pressure of the fluid injected into the sample while breaking the separation layer.

The separating apparatus according to the first aspect of the present invention preferably further comprises a limiting member for limiting the expansion amount near the central portion of the sample.

In the separating apparatus according to the first aspect of the present invention, preferably, the sample has, e.g., a disk shape, and the enclosed space forming member forms the enclosed space, e.g., around the entire peripheral portion of the sample.

In the separating apparatus according to the first aspect of the present invention, the enclosed space forming member preferably has, e.g., an annular shape.

In the separating apparatus according to the first aspect of the present invention, preferably, the enclosed space forming member comprises, e.g., a pair of support members for sandwiching the peripheral portion of the sample from both sides and supporting the sample, and the enclosed space is formed around the entire peripheral portion of the sample while the sample is supported by the pair of support members.

In the separating apparatus according to the first aspect of the present invention, each of the pair of support members preferably has, e.g., a sealing member along the edge of the sample.

In the separating apparatus according to the first aspect of the present invention, preferably, the sample has, e.g., a disk shape, and the sealing member has, e.g., an annular shape.

In the separating apparatus according to the first aspect of the present invention, each of the pair of support members preferably has, e.g., an annular shape.

In the separating apparatus according to the first aspect of the present invention, preferably, the pressure application mechanism comprises, e.g., a pair of support members for sandwiching the sample from both sides and supporting the sample, each of the support members having, e.g., a sealing member located along the edge of the sample to form an enclosed space around a peripheral portion of the sample, and the pressure application mechanism applies a pressure higher than that of an external space to the enclosed space.

In the separating apparatus according to the first aspect of the present invention, each of the pair of support members preferably has, e.g., a structure for connecting a space formed inside the sealing member to the external space while supporting the sample.

In the separating apparatus according to the first aspect of the present invention, preferably, each of the pair of support members comprises, e.g., a plate member for covering both the sides of the sample while supporting the sample, the plate member having a through hole.

In the separating apparatus according to the first aspect of the present invention, the pressure application mechanism preferably has, e.g., an injection portion for injecting the fluid into the enclosed space.

In the separating apparatus according to the first aspect of the present invention, the pressure application mechanism preferably has, e.g., a pressure adjustment mechanism for adjusting the pressure to be applied to the separation layer.

In the separating apparatus according to the first aspect of the present invention, the pressure adjustment mechanism preferably gradually or stepwise reduces the pressure to be applied to the separation layer to separate the sample.

In the separating apparatus according to the first aspect of the present invention, for example, water is preferably used as the fluid.

The separation layer is preferably, e.g., a layer having a fragile structure. The separation layer is preferably, e.g., a porous layer. The separation layer is preferably, e.g., a layer having microcavities. The microcavities are preferably formed by, e.g., ion implantation.

The sample preferably has, at the edge, a groove having a substantially V-shaped section.

According to the second aspect of the present invention, there is provided a separating method of separating a sample having a separation layer at the separation layer, characterized by comprising the separation step of applying a pressure of a fluid substantially standing still at least part of the separation layer to separate the sample at the separation layer.

In the separating method according to the second aspect of the present invention, preferably, the separation layer, e.g., extends across in the sample and is exposed to an edge of the sample, and the separation step comprises, e.g., applying the pressure of the fluid to the separation layer from at least part of the edge of the sample.

In the separating method according to the second aspect of the present invention, the separation step preferably comprises, e.g., forming an enclosed space by surrounding at least part of a peripheral portion of the sample, filling the enclosed space with the fluid, and applying a pressure higher than that of an external space to the fluid.

In the separating method according to the second aspect of the present invention, the separation step preferably comprises separating the sample, while allowing the sample to expand near a central portion due to the pressure of the fluid which is injected into the sample and breaks the separation layer and limiting the expansion amount.

In the separating method according to the second aspect of the present invention, preferably, the sample has, e.g., a disk shape, and the separation step comprises, e.g., forming the enclosed space around the entire peripheral portion of the sample and applying the pressure higher than that of the external space to the enclosed space.

In the separating method according to the second aspect of the present invention, the separation step preferably comprises, e.g., separating the sample while changing the pressure to be applied to the separation layer.

In the separating method according to the second aspect of the present invention, the separation step preferably comprises, e.g., separating the sample while gradually or stepwise reducing the pressure to be applied to the separation layer.

In the separating method according to the second aspect of the present invention, the separation step preferably comprises, e.g., separating the sample while changing the pressure to be applied to the fluid in the enclosed space.

In the separating method according to the second aspect of the present invention, the separation step preferably comprises, e.g., separating the sample while gradually or stepwise reducing the pressure to be applied to the fluid in the enclosed space.

As the fluid, for example, water is preferably used.

The separation layer is preferably, e.g., a layer having a fragile structure. The separation layer is preferably, e.g., a porous layer. The separation layer is preferably a layer having microcavities. The microcavities are preferably formed by, e.g., ion implantation.

The sample preferably has, at the edge, a groove having a substantially V-shaped section.

According to the third aspect of the present invention, there is provided a method of manufacturing a semiconductor substrate, characterized by comprising the first step of forming a first substrate having a separation layer and, on the separation layer, a semiconductor layer to be transferred to onto a second substrate later, the second step of bonding the first substrate to the second substrate via the semiconductor layer to form a bonded substrate stack, and the third step of separating the bonded substrate stack at the separation layer by the above separating method to transfer the -semiconductor layer from the first substrate to the second substrate.

The separation layer is preferably, e.g., a porous layer. The porous layer preferably comprises a plurality of layers having different porosities.

In the semiconductor substrate manufacturing method according to the third aspect of the present invention, for example, the first step preferably comprises using an Si substrate as a material of the first substrate and anodizing the Si substrate to form the porous layer.

In the semiconductor substrate manufacturing method according to the third aspect of the present invention, the first step preferably comprises forming, as the semiconductor layer, e.g., a single-crystal Si layer on the porous layer by epitaxial growth.

In the semiconductor substrate manufacturing method according to the third aspect of the present invention, the first step preferably comprises further forming an insulating layer on the single-crystal Si layer.

In the semiconductor substrate manufacturing method according to the third aspect of the present invention, for example, the insulating layer is preferably formed by oxidizing a surface of the single-crystal Si layer.

In the semiconductor substrate manufacturing method according to the third aspect of the present invention, the second substrate is preferably, e.g., an Si substrate.

In the semiconductor substrate manufacturing method according to the third aspect of the present invention, the second substrate is preferably, e.g., a transparent substrate.

The separation layer is preferably, e.g., a layer having microcavities. The microcavities are formed by, e.g., ion implantation.

According to the fourth aspect of the present invention, there is provided a separating method of separating a sample having a cavity-containing layer with a number of cavities at the cavity-containing layer, characterized by comprising the storing step of storing the sample in a closed vessel, and the separation step of setting an internal space of the closed vessel at a high pressure to break cavity walls in the cavity-containing layer and separate at least part of the sample at the cavity-containing layer.

In the separating method according to the fourth aspect of the present invention, for example, the separation step preferably comprises applying a pressure into the closed vessel such that the cavity walls break due to a pressure difference between a pressure in the cavity walls and that in the closed vessel.

The separating method according to the fourth aspect of the present invention preferably further comprises, e.g., the final separation step of breaking the cavity-containing layer remaining after the separation step as an unseparated region to completely separate the sample.

In the separating method according to the fourth aspect of the present invention, the final separation step preferably comprises applying a vibration energy to the sample to break the cavity-containing layer remaining after the separation step as the unseparated region.

In the separating method according to the fourth aspect of the present invention, for example, the final separation step is preferably executed while the sample is being stored in the closed vessel.

In the separating method according to the fourth aspect of the present invention, for example, the final separation step preferably comprises applying a press force to the sample to break the cavity-containing layer remaining after the separation step as the unseparated region.

In the separating method according to the fourth aspect of the present invention, for example, the final separation step preferably comprises applying a tensile force to the sample to break the cavity-containing layer remaining after the separation step as the unseparated region.

In the separating method according to the fourth aspect of the present invention, for example, the final separation step preferably comprises applying a force to the sample in a direction parallel to the cavity-containing layer to break the cavity-containing layer remaining after the separation step as the unseparated region.

In the separating method according to the fourth aspect of the present invention, for example, the final separation step preferably comprises inserting a member into the cavity-containing layer to break the cavity-containing layer remaining after the separation step as the unseparated region.

In the separating method according to the fourth aspect of the present invention, for example, the final separation step preferably comprises soaking the cavity-containing layer with a liquid and heating the liquid.

In the separating method according to the fourth aspect of the present invention, for example, the final separation step preferably comprises soaking the cavity-containing layer with a liquid and cooling the liquid.

In the separating method according to the fourth aspect of the present invention, for example, the final separation step preferably comprises soaking the cavity-containing layer with a substance of liquid condition and expanding the volume of the substance.

In the separating method according to the fourth aspect of the present invention, for example, the final separation step preferably comprises ejecting a stream of a fluid toward a gap in the sample, which is formed in the separation step, to break the cavity-containing layer remaining after the separation step as the unseparated region.

In the separating method according to the fourth aspect of the present invention, for example, the cavity-containing layer is preferably a porous layer.

In the separating method according to the fourth aspect of the present invention, for example, the cavity-containing layer is preferably a porous layer formed by anodizing.

In the separating method according to the fourth aspect of the present invention, for example, the cavity-containing layer is preferably a microcavity layer having-bubble-like microcavities.

In the separating method according to the fourth aspect of the present invention, for example, the cavity-containing layer is a microcavity layer having bubble-like microcavities formed by ion implantation.

In the separating method according to the fourth aspect of the present invention, for example, the sample is preferably formed by bonding a first plate member having the cavity-containing layer to a second plate member.

According to the fifth aspect of the present invention, there is provided a separating apparatus for separating a sample having a cavity-containing layer with a number of cavities at the cavity-containing layer, characterized by comprising a vessel for storing the sample, and an injection portion for injecting a high-pressure fluid into the vessel to break cavity walls in the cavity-containing layer with the pressure of the fluid and separate at least part of the sample at the cavity-containing layer.

The separating apparatus according to the fifth aspect of the present invention preferably further comprises, e.g., a vibration source for supplying a vibration energy into the vessel.

According to the sixth aspect of the present invention, there is provided a method of manufacturing a substrate, characterized by comprising the step of forming a first substrate having a cavity-containing layer with a number of cavities and, on the cavity-containing layer, a non-cavity-containing layer, the bonding step of bonding the first substrate and an independently prepared second substrate via the non-cavity-containing layer to form a bonded substrate stack, the separation step of storing the bonded substrate stack in a closed vessel and setting an internal space of the closed vessel at a high pressure to break cavity walls in the cavity-containing layer and separate at least part of the bonded substrate stack at the cavity-containing layer.

In the substrate manufacturing method according to the sixth aspect of the present invention, for example, the separation step preferably comprises applying a pressure into the closed vessel such that the cavity walls break due to a pressure difference between a pressure in the cavity walls and that in the closed vessel.

The substrate manufacturing method according to the sixth aspect of the present invention preferably further comprises, e.g., the final separation step of breaking the cavity-containing layer remaining after the separation step as an unseparated region to completely separate the bonded substrate stack.

In the substrate manufacturing method according to the sixth aspect of the present invention, for example, the final separation step preferably comprises applying a vibration energy to the bonded substrate stack to break the cavity-containing layer remaining after the separation step as the unseparated region.

In the substrate manufacturing method according to the sixth aspect of the present invention, for example, the final separation step is preferably executed while the bonded substrate stack is being stored in the closed vessel.

In the substrate manufacturing method according to the sixth aspect of the present invention, for example, the final separation step preferably comprises applying a press force to the bonded substrate stack to break the cavity-containing layer remaining after the separation step as the unseparated region.

In the substrate manufacturing method according to the sixth aspect of the present invention, for example, the final separation step preferably comprises applying a tensile force to the bonded substrate stack to break the cavity-containing layer remaining after the separation step as the unseparated region.

In the substrate manufacturing method according to the sixth aspect of the present invention, for example, the final separation step preferably comprises applying a force to the bonded substrate stack in a direction parallel to the cavity-containing layer to break the cavity-containing layer remaining after the separation step as the unseparated region.

In the substrate manufacturing method according to the sixth aspect of the present invention, for example, the final separation step preferably comprises soaking the cavity-containing layer with a liquid and heating or cooling the liquid.

In the substrate manufacturing method according to the sixth aspect of the present invention, for example, the final separation step preferably comprises ejecting a stream of a fluid toward a gap in the bonded substrate stack, which is formed in the separation step, to break the cavity-containing layer remaining after the separation step as the unseparated region.

In the substrate manufacturing method according to the sixth aspect of the present invention, for example, the cavity-containing layer is preferably a porous layer.

In the substrate manufacturing method according to the sixth aspect of the present invention, for example, the cavity-containing layer is a porous layer formed by anodizing.

In the substrate manufacturing method according to the sixth aspect of the present invention, for example, the cavity-containing layer is preferably a microcavity layer having bubble-like microcavities.

In the substrate manufacturing method according to the sixth aspect of the present invention, for example, the cavity-containing layer is preferably a microcavity layer having bubble-like microcavities formed by ion implantation.

In the substrate manufacturing method according to the sixth aspect of the present invention, for example, the non-cavity-containing layer preferably includes an Si layer.

In the substrate manufacturing method according to the sixth aspect of the present invention, for example, the non-cavity-containing layer is preferably an Si layer having an insulating layer on a surface.

In the substrate manufacturing method according to the sixth aspect of the present invention, for example, the insulating layer is preferably an Si oxide layer.

In the substrate manufacturing method according to the sixth aspect of the present invention, for example, the Si layer is preferably a single-crystal Si layer.

In the substrate manufacturing method according to the sixth aspect of the present invention, for example, the non-cavity-containing layer is preferably a compound semiconductor layer.

In the substrate manufacturing method according to the sixth aspect of the present invention, for example, the non-cavity-containing layer is preferably a compound semiconductor layer having an insulating layer on a surface.

In the substrate manufacturing method according to the sixth aspect of the present invention, for example, the non-cavity-containing layer is preferably a layer including a semiconductor element.

In the substrate manufacturing method according to the sixth aspect of the present invention, for example, the first substrate is preferably a single-crystal Si substrate.

In the substrate manufacturing method according to the sixth aspect of the present invention, for example, the second substrate is preferably a single-crystal Si substrate.

In the substrate manufacturing method according to the sixth aspect of the present invention, for example, the second substrate is preferably a single-crystal Si substrate having an Si oxide layer on a surface.

In the substrate manufacturing method according to the sixth aspect of the present invention, for example, the second substrate is preferably a transparent substrate.

In the substrate manufacturing method according to the sixth aspect of the present invention, for example, the second substrate is preferably a resin substrate.

In the substrate manufacturing method according to the sixth aspect of the present invention, for example, the second substrate is preferably a substrate as a main body of an IC card.

In the substrate manufacturing method according to the sixth aspect of the present invention, for example, the bonding step preferably comprises one of the anode bonding step, the pressing step, the heating step, and a combination thereof.

The substrate manufacturing method according to the sixth aspect of the present invention preferably further comprises, e.g., the removing step of, after the bonded substrate stack is completely separated, removing the cavity-containing layer remaining on the second substrate.

In the substrate manufacturing method according to the sixth aspect of the present invention, for example, the removing step preferably comprises the etching step.

In the substrate manufacturing method according to the sixth aspect of the present invention, for example, the removing step preferably comprises the polishing step.

The substrate manufacturing method according to the sixth aspect of the present invention preferably further comprises, e.g., after the removing step, the planarization step of planarizing a surface of the non-cavity-containing layer on the second substrate.

In the substrate manufacturing method according to the sixth aspect of the present invention, for example, the planarization step preferably comprises the polishing step.

In the substrate manufacturing method according to the sixth aspect of the present invention, for example, the planarization step preferably comprises annealing in an atmosphere containing hydrogen.

The substrate manufacturing method according to the sixth aspect of the present invention preferably further comprises, e.g., the step of, after the bonded substrate stack is completely separated, removing the cavity-containing layer remaining on the first substrate to allow reuse of the substrate.

In the substrate manufacturing method according to the sixth aspect of the present invention, for example, the substrate is preferably obtained by forming a first substrate having a cavity-containing layer with a number of cavities and, on the cavity-containing layer, a non-cavity-containing layer, bonding the first substrate and an independently prepared second substrate via the non-cavity-containing layer to form a bonded substrate stack, storing the bonded substrate stack in a closed vessel and setting an internal space of the closed vessel at a high pressure to break cavity walls in the cavity-containing layer and separate at least part of the bonded substrate stack at the cavity-containing layer.

Further objects, features and advantages of the present invention will become apparent from the following detailed description of the embodiments of the present invention with reference to the accompanying drawings.

BRIEF DESCRIPTION OF THE DRAWINGS

Figs. 1A to 1E are sectional views for explaining steps in manufacturing an SOI substrate according a preferred embodiment of the present invention;

Fig. 2 is a view schematically showing the arrangement of a separating apparatus according to the first mode of the present invention;

Fig. 3 is a sectional view showing the closed state of a separating apparatus according to the first embodiment of the first mode of the present invention;

Fig. 4 is a plan view showing the opened state of the separating apparatus shown in Fig. 3;

Fig. 5 is a sectional view showing the closed state of a separating apparatus according to the second embodiment of the first mode of the present invention;

Fig. 6 is a plan view showing the opened state of the separating apparatus shown in Fig. 5;

Fig. 7 is a sectional view showing the closed state of a separating apparatus according to the third embodiment of the first mode of the present invention;

Fig. 8 is a sectional view showing the closed state of a separating apparatus according to the fourth embodiment of the first mode of the present invention;

Fig. 9 is a view schematically showing a process of separating a sample having a cavity-containing layer (porous layer) by pressure in the second mode of the present invention;

Fig. 10 is a view schematically showing a process of separating a sample having a cavity-containing layer (porous layer) by pressure;

Fig. 11 is a view schematically showing a process of separating a sample having a cavity-containing layer (porous layer) by pressure;

Fig. 12 is a view schematically showing a process of separating a sample having a cavity-containing layer (microcavity layer) by pressure;

Fig. 13 is a view schematically showing a process of separating a sample having a cavity-containing layer (microcavity layer) by pressure;

Fig. 14 is a view schematically showing a process of separating a sample having a cavity-containing layer (microcavity layer) by a pressure;

Fig. 15 is a view schematically showing the state of a sample in which cavity walls in a cavity-containing layer are not completely broken;

Fig. 16 is a view schematically showing the arrangement of a sample separating apparatus according to the second mode of the present invention;

Fig. 17 is a view schematically showing the arrangement of a separation apparatus suitable to execute the second separation processing;

Fig. 18 is a view schematically showing the arrangement of another separation apparatus suitable to execute the second separation processing;

Figs. 19A to 19E are sectional views for explaining steps in manufacturing an SOI substrate according to a preferred embodiment of the present invention; and

Fig. 20 is a view schematically showing the arrangement of an IC card.

DETAILED DESCRIPTION OF THE PREFERRED EMBODIMENTS

Preferred embodiments of the present invention will be described below with reference to the accompanying drawings.

[First Mode]

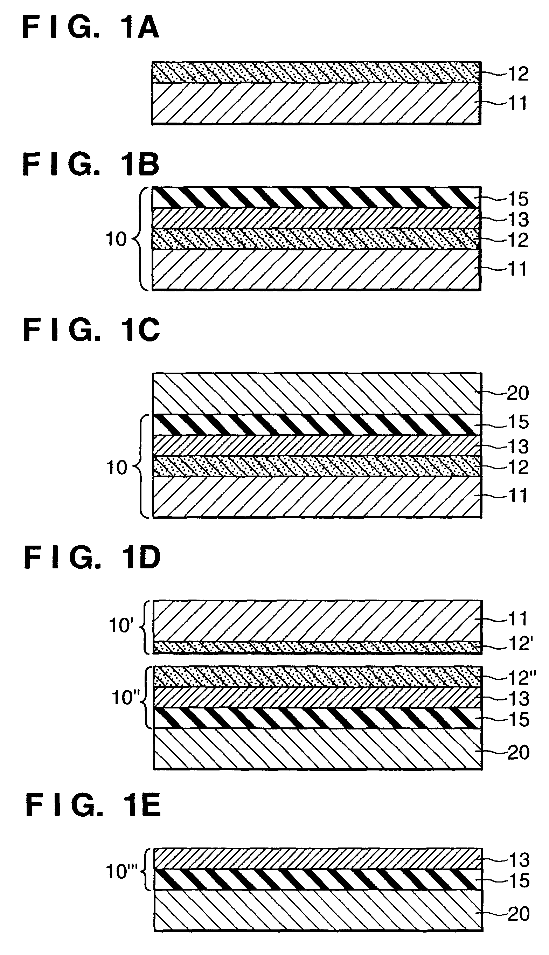

Figs. 1A to 1E are sectional views for explaining steps in manufacturing an SOI substrate according a preferred embodiment of the present invention.

In the step shown in Fig. 1A, a single-crystal Si substrate 11 is prepared, and a porous Si layer 12 is formed on the surface of the single-crystal Si substrate 11 by, e.g., anodizing. The porous Si layer 12 may have a multilayered structure having layers with different porosities. For example, a first porous layer having a low porosity is formed on the upper surface side, and a second porous layer having a high porosity is formed under the first porous layer. The first porous layer is used to form a satisfactory non-porous single-crystal Si layer thereon in the next process, and the second porous layer can be used as a separation layer.

In the step shown in Fig. 1B, a porous single-crystal Si layer 13 is formed on the porous Si layer 12 by epitaxial growth. An insulating layer (e.g., $SiO_2$ layer)

15 is formed on the porous single-crystal Si layer 13. With this process, a first substrate 10 is formed.

In the step shown in Fig. 1C, a second substrate 20 is prepared and brought into tight contact with the first substrate 10 at room temperature while making the insulating layer 15 oppose the second substrate 20. After this, the first substrate 10 and second substrate 20 are bonded by anode bonding, pressing, heating, or a combination thereof. The insulating layer 15 and second substrate 20 are firmly bonded. The insulating layer 15 may be formed on the porous single-crystal Si layer 13, as described above. Alternatively, the insulating layer 15 may be formed either on the second substrate 20 or on both the porous single-crystal Si layer 13 and second substrate 20 as far as the state shown in Fig. 1C is obtained upon bringing the first and second substrates into tight contact with each other.

In the step shown in Fig. 1D, the two bonded substrates are separated at the porous Si layer 12. The second substrate side (10" + 20) has a multilayered structure of porous Si layer 12"/single-crystal Si layer 13/insulating layer 15/single-crystal Si substrate 20. The first substrate side (10') has a structure wherein a porous Si layer 12' is formed on the single-crystal Si substrate 11.

After the remaining porous Si layer 12' is removed, and the surface of the porous Si layer 12' is planarized as needed, the separated substrate (10') is used as a single-crystal Si substrate 11 for forming a first substrate 10 again.

After the bonded substrate stack is separated, in the step shown in Fig. 1E, the porous layer 12" on the surface on the second substrate side (10" + 20) is selectively removed. With this process, a substrate having a multilayered structure of a porous single-crystal Si layer 13/insulating layer 15/single-crystal Si substrate 20, i.e., an SOI structure is obtained.

As the second substrate, for example, not only a single-crystal Si substrate but also an insulating substrate (e.g., silica substrate) or a transparent substrate (e.g., silica substrate) can be used.

In this first mode, to facilitate the process of bonding two substrates and separating them, a porous Si layer 12 having a fragile structure is formed as a separation layer. In place of the porous layer, for example, a microcavity layer having microcavities may be formed. The microcavity layer can be formed by, e.g., implanting ions into a semiconductor substrate.

A separating apparatus suitable for the step shown in Fig. 1D, i.e., the process of separating the bonded substrate stack will be described below. The separating apparatus to be described below can be applied to separate not only the bonded substrate stack but also a sample (member) having a separation layer.

[Principle of Separating Apparatus]

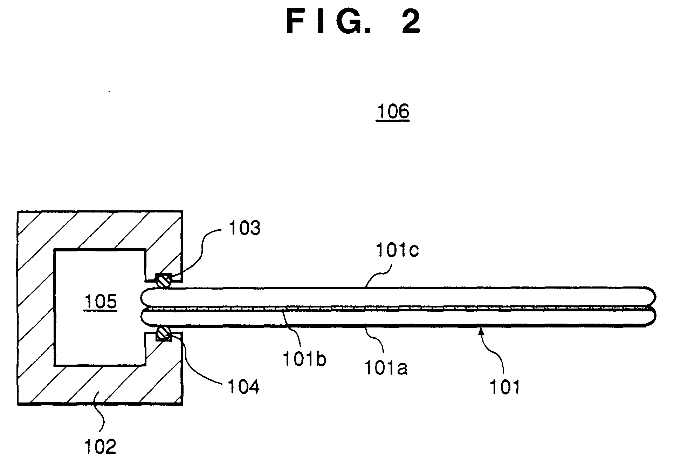

The principle of a separating apparatus according to the first mode of the present invention will be described first. Fig. 2 is a view schematically showing the arrangement of a separating apparatus according to the first mode of the present invention. A bonded substrate stack 101 as a sample to be separated has a porous layer 101b as a separation layer. The bonded substrate stack 101 is separated into two substrates 101a and 101c at the porous layer 101b. The separation layer need only be more fragile than the remaining portions. The separation layer is not limited to the porous layer 101b, and instead, the above-described microcavity layer may be used.

The porous layer 101b as the separation layer preferably extends across in the bonded substrate stack 101 and is exposed to the edge of the bonded substrate stack 101, as shown in Fig. 2.

The porous layer 101b corresponds to the porous layer 12 shown in Fig. 1A. The substrate 101a corresponds to the first substrate side (10') shown in Fig. 1D. The substrate 101c corresponds to the second substrate side (10" + 20) shown in Fig. 1D.

In this separating apparatus, a region including at least part (e.g., part of the side surface) of the porous layer 101b as the separation layer is closed by an enclosed space forming member 102. Using a fluid substantially standing still, a pressure (e.g., a pressure sufficiently higher than the atmospheric pressure) is caused to act on the porous layer 101b exposed to an enclosed space 105 formed by the member 102. The enclosed space forming member 102 has sealing members 103 and 104. As the fluid to be supplied to the enclosed space 105, not only a liquid such as water but also a gas such as air can be used. An unclosed space 106, i.e., the space that is not closed by the enclosed space forming member 102 is exposed to, e.g., the atmospheric pressure.

Separation of the bonded substrate stack 101 progresses in the following way. First, the porous layer 101b at the portion exposed to the enclosed space 105 breaks by the pressure of the fluid. As the fluid is injected into the broken portion, break of the porous layer 101b progresses. When break of the porous layer 101b progresses and the fluid is sufficiently injected into the bonded substrate stack 101, a separation force acts on the bonded substrate stack 101 to separate the substrates 101a and 101c due to the difference between the pressure of the fluid acting on the interior of the bonded substrate stack 101 and that (e.g., atmospheric pressure) in the unclosed space 106. Separation progresses with this separation force.

At the early stage of separation and, more particularly, at the stage where the porous layer 101b outside the sealing members 103 and 104 breaks, the separation force acting on the bonded substrate stack 101 is weak. Hence, the pressure of the fluid in the enclosed space 105 is preferably increased. After the early stage of separation, the separation force acting on the bonded substrate stack 101 gradually increases. Hence, the pressure of the fluid is preferably gradually or stepwise reduced.

When the separation force is excessively large, and the warp amounts of the substrates 101a and 110c become large, the substrates 101a and 110c may be damaged. To prevent this, a limiting member for limiting the warp amount is preferably disposed.

To facilitate start of separation of the bonded substrate stack 101, for example, a groove having a V-shaped section is preferably formed in the side surface of the bonded substrate stack 101.

To efficiently separate the bonded substrate stack 101, or facilitate formation of the enclosed space 105, the enclosed space 105 is preferably formed to entirely close the side surface of the bonded substrate stack 101.

In the above description, the enclosed space 105 is formed at the portion (to be referred to as a high-pressure applied portion hereinafter) where the pressure of the fluid acts on the porous layer 101b, and the remaining portion (to be referred to as a low-pressure applied portion hereinafter) is set in the unclosed space 106.

Conversely, the high-pressure applied portion may be set in the unclosed space, and the enclosed space may be formed at the low-pressure applied portion such that the high-pressure applied portion is exposed to, e.g., the atmospheric pressure, and the low-pressure applied portion is exposed to a pressure sufficiently lower than the atmospheric pressure.

Alternatively, both the high-pressure applied portion and low-pressure applied portion may be set in the enclosed space. A relatively higher pressure is applied to the high-pressure applied portion while a relatively lower pressure is applied to the low-pressure applied portion.

With the above method, the bonded substrate stack can be separated without damaging the substrates to be separated.

A separating apparatus according to the first embodiment of the first mode of the present invention will be described below.

[First Embodiment]

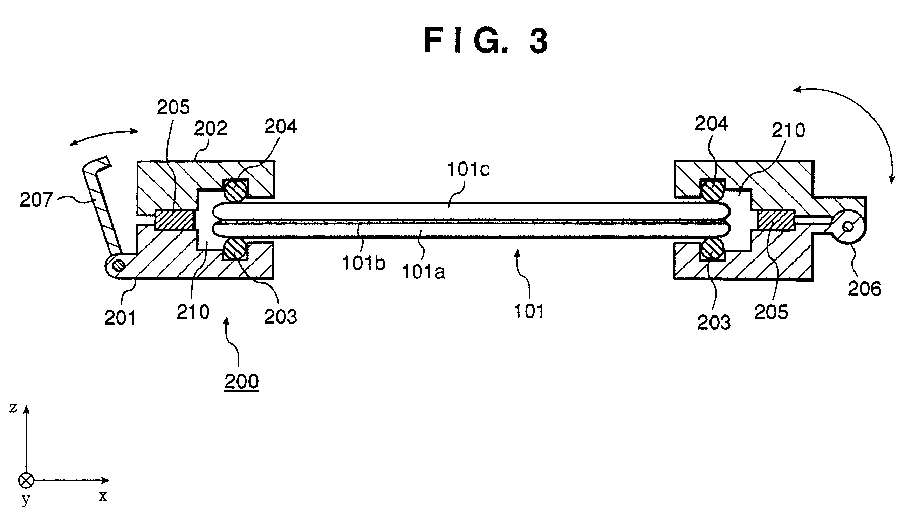

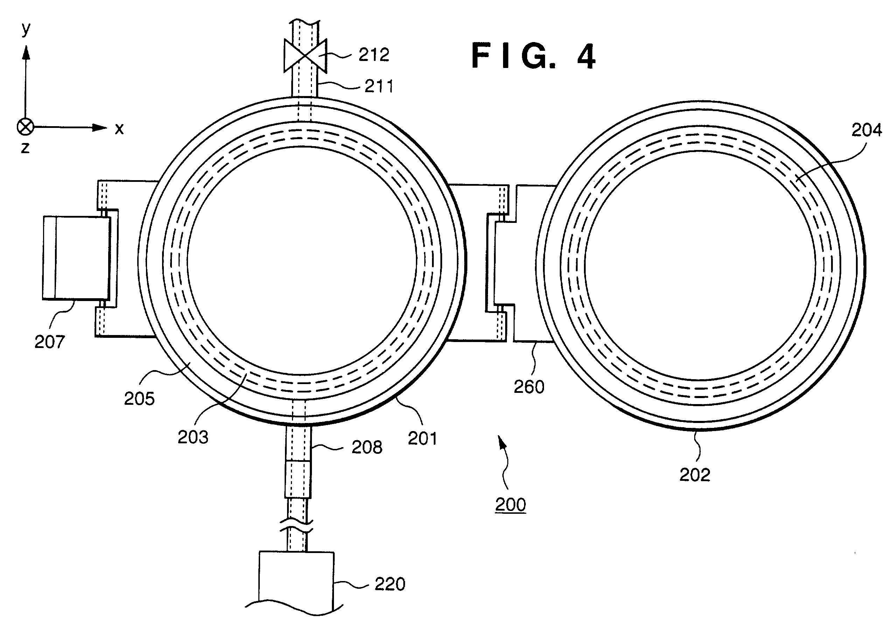

Fig. 3 is a sectional view showing the closed state of a separating apparatus according to the first embodiment. Fig. 4 is a plan view showing the opened state of the separating apparatus shown in Fig. 3. The bonded substrate stack 101 is not illustrated in Fig. 4.

A separating apparatus 200 has a pair of substrate supporting members 201 and 202 coupled through a hinge portion 206. Each of the substrate supporting members 201 and 202 has an annular shape conforming to the side surface of the bonded substrate stack 101. The substrate supporting members 201 and 202 function as enclosed space forming members which close while sandwiching the bonded substrate stack and form an enclosed space 210 around the edge portion of the bonded substrate stack 101 where the porous layer 101b is exposed.

The substrate supporting members 201 and 202 respectively have sealing members (e.g., O rings) 203 and 204 for ensuring airtightness between the members 201 and 202 and the bonded substrate stack 101. The substrate supporting member 201 has a sealing member 205 for ensuring airtightness between the substrate supporting members 201 and 202.

In the separating apparatus 200, while the bonded substrate stack 101 is sandwiched and supported by the substrate supporting members 201 and 202 from both sides, the substrate supporting member 202 is locked by a lock mechanism 207.

The substrate supporting member 201 has an injection portion 208 for injecting a fluid into the enclosed space 210. The injection portion 208 is connected to a pressure source 220 such as a pump. The enclosed space 210 is filled with the fluid (e.g., water) supplied from the pressure source 220.

The substrate supporting member 201 and/or 202 may have a deaeration port 211 for removing bubbles generated upon injecting the fluid into the enclosed space 210, and a valve 212 for closing the deaeration port 211 when pressure is applied to the fluid in the enclosed space 210.

The pressure source 220 applies pressure to the fluid with which the enclosed space 210 is filled. The pressure source 220 preferably has a mechanism for adjusting the pressure to be applied to the fluid. With this mechanism, the pressure to be applied to the fluid is preferably set to be high at the early stage of separation of the bonded substrate stack 101 and then gradually or stepwise reduced. For example, at the early stage of separation, the pressure is set at, e.g., 20 kg/cm$^2$ and then gradually reduced to, e.g., 1 kg/cm$^2$ at the final stage of separation.

The processing procedure for separating the bonded substrate stack 101 by the separating apparatus 200 will be described below. Separation processing is performed under, e.g., the atmospheric pressure.

First, the substrate supporting member 202 is unlocked by the lock mechanism 207 and opened, as shown in Fig. 4. The bonded substrate stack 101 is placed on the substrate supporting member 201. As shown in Fig. 3, the substrate supporting member 202 is closed and locked by the lock mechanism 207. In this state, the enclosed space 210 is formed around the edge portion of the bonded substrate stack 101 where the porous layer 101b is exposed.

A fluid is injected into the enclosed space 210 by the pressure source 220. Pressure is applied to the fluid in the enclosed space 210 by the pressure source 220. The pressure of the fluid substantially standing still is applied to the porous layer 101b exposed to the edge of the bonded substrate stack 101.

Separation starts as the applied pressure breaks the porous layer 101b exposed to the edge of the bonded substrate stack 101. When the fluid is injected into the broken portion, break of the porous layer 101b progresses. As break of the porous layer 101b progresses, the fluid is sufficiently injected into the bonded substrate stack 101. At this time, due to the difference between the pressure of the fluid acting on the interior of the bonded substrate stack 101 and that acting on the unclosed space (space other than the enclosed space), a separation force acts on the bonded substrate stack 101 to separate the substrates 101a and 101c. Separation progresses with this separation force.

When separation is ended, the pressure source 220 is controlled to set the enclosed space 210 at the atmospheric pressure. After this, the substrate supporting member 202 is unlocked by the lock mechanism 207 and opened. The separated substrates 101a and 101c are extracted.

[Second Embodiment]

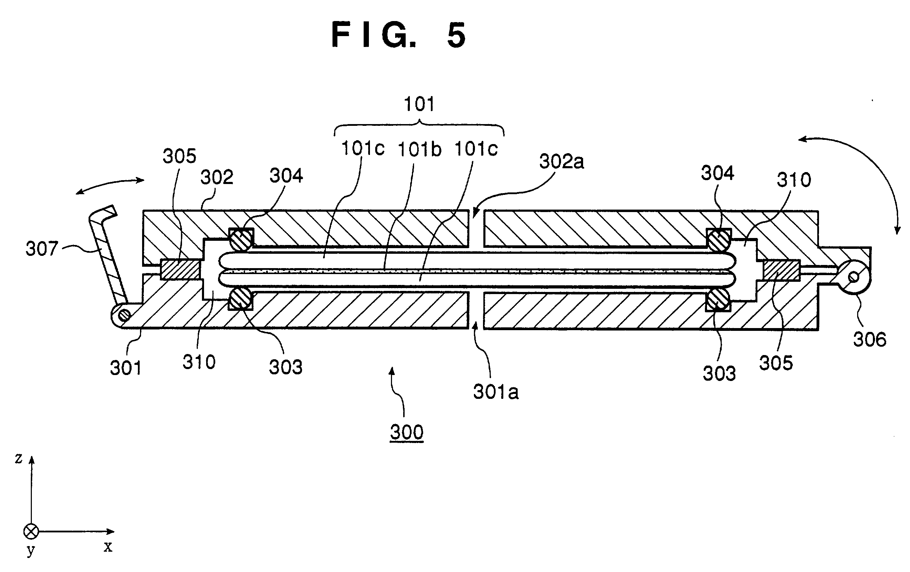

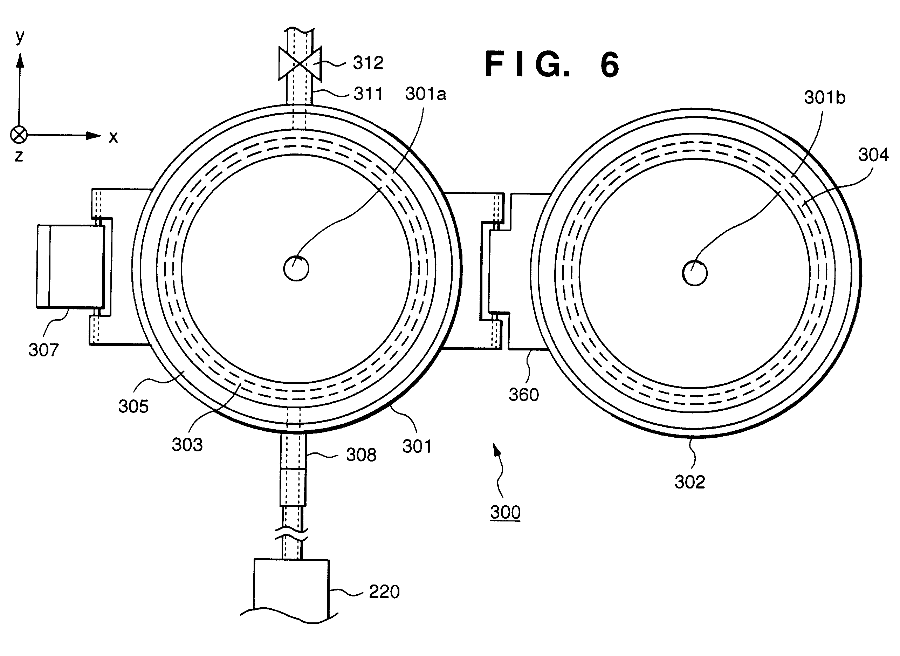

Fig. 5 is a sectional view showing the closed state of a separating apparatus according to the second embodiment. Fig. 6 is a plan view showing the opened state of the separating apparatus shown in Fig. 5. A bonded substrate stack 101 is not illustrated in Fig. 6.

A separating apparatus 300 allows the bonded substrate stack 101 to warp during separation processing while limiting the warp amount to prevent damage to the bonded substrate stack 101.

The separating apparatus 300 has a pair of substrate supporting members 301 and 302 coupled through a hinge portion 306. Each of the substrate supporting members 301 and 302 has a disk shape. A part near the central portion of each member functions as a limiting member for limiting the warp amount near the central portion of the bonded substrate stack 101. The warp amount of the bonded substrate stack 101 is preferably limited to, e.g., about 50 μm.

The substrate supporting members 301 and 302 function as enclosed space forming members which close while sandwiching the bonded substrate stack 101 and form an enclosed space 310 around the edge portion of the bonded substrate stack 101 where a porous layer 101b is exposed.

The substrate supporting members 301 and 302 respectively have sealing members (e.g., O rings) 303 and 304 for ensuring airtightness between the members 301 and 302 and the bonded substrate stack 101. The substrate supporting member 301 has a sealing member 305 for ensuring airtightness between the substrate supporting members 301 and 302.

The substrate supporting members 301 and 302 have through holes 301a and 302a, respectively, through which the spaces inside the bonded substrate stack 101, i.e., inside the sealing members 303 and 304 communicate with the external space. When the bonded substrate stack 101 expands as substrates 101a and 101c warp, the holes 301a and 302a can prevent the pressures in the spaces inside the sealing members 303 and 304 from increasing.

In the separating apparatus 300, while the bonded substrate stack 101 is sandwiched and supported by the substrate supporting members 301 and 302 from both sides, the substrate supporting member 302 is locked by a lock mechanism 307.

The substrate supporting member 301 has an injection portion 308 for injecting a fluid into the enclosed space 310. The injection portion 308 is connected to a pressure source 220 such as a pump. The enclosed space 310 is filled with the fluid (e.g., water) supplied from the pressure source 220.

The substrate supporting member 301 and/or 302 may have a deaeration port 311 for removing bubbles generated upon injecting the fluid into the enclosed space 310, and a valve 312 for closing the deaeration port 311 when pressure is applied to the fluid in the enclosed space 310.

The pressure source 220 applies pressure to the fluid with which the enclosed space 310 is filled. The pressure source 220 preferably has a mechanism for adjusting the pressure to be applied to the fluid. With this mechanism, the pressure to be applied to the fluid is preferably set to be high at the early stage of separation of the bonded substrate stack 101 and then gradually or stepwise reduced. For example, at the early stage of separation, the pressure is set at, e.g., 20 kg/cm and then gradually reduced to, e.g., 1 kg/cm$^2$ at the final stage of separation.

The processing procedure for separating the bonded substrate stack 101 by the separating apparatus 300 will be described below. Separation processing is performed under, e.g., the atmospheric pressure.

First, the substrate supporting member 302 is unlocked by the lock mechanism 307 and opened, as shown in Fig. 6. The bonded substrate stack 101 is placed on the substrate supporting member 301. As shown in Fig. 5, the substrate supporting member 302 is closed and locked by the lock mechanism 307. In this state, the enclosed space 310 is formed around the edge portion of the bonded substrate stack 101 where the porous layer 101b is exposed.

A fluid is injected into the enclosed space 310 by the pressure source 220. Pressure is applied to the fluid in the enclosed space 310 by the pressure source 220. The pressure of the fluid substantially standing still is applied to the porous layer 101b exposed to the edge of the bonded substrate stack 101.

Separation starts as the applied pressure breaks the porous layer 101b exposed to the edge of the bonded substrate stack 101. When the fluid is injected into the broken portion, break of the porous layer 101b progresses. As break of the porous layer 101b progresses, the fluid is sufficiently injected into the bonded substrate stack 101. At this time, due to the difference between the pressure of the fluid acting on the interior of the bonded substrate stack 101 and that acting on the unclosed space (space other than the enclosed space), a separation force acts on the bonded substrate stack 101 to separate the substrates 101a and 101c. The substrates 101a and 101c warp due to this separation force. The warp amount is limited by the inside surfaces of the substrate supporting members 301 and 302, which function as limiting members for limiting the warp amount of the bonded substrate stack 101.

When separation is ended, the pressure source 220 is controlled to set the enclosed space 310 at the atmospheric pressure. After this, the substrate supporting member 302 is unlocked by the lock mechanism 307 and opened. The separated substrates 101a and 101c are extracted.

[Third Embodiment]

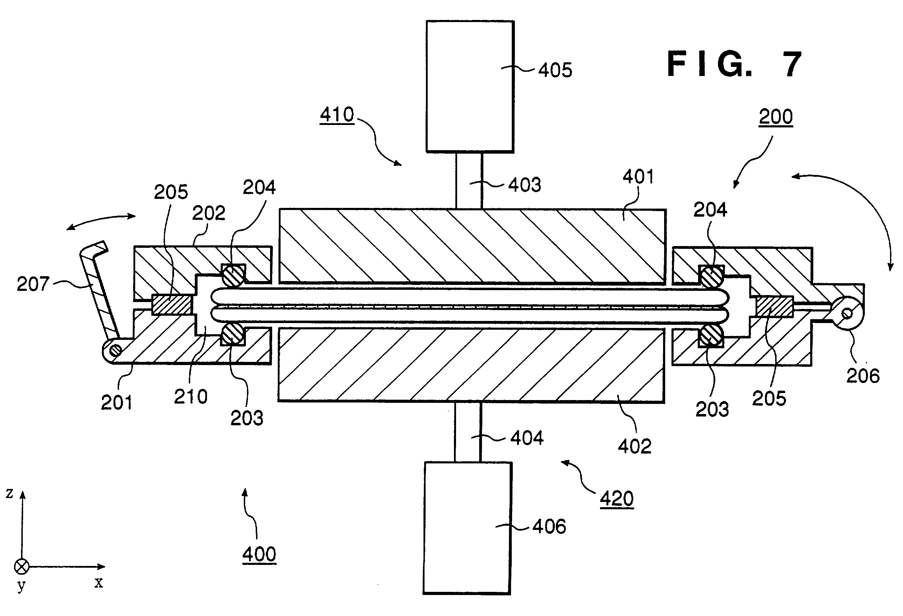

In this embodiment, the warp amount is limited by pressing a bonded substrate stack 101 by a press mechanism from both sides. Fig. 7 is a sectional view showing the arrangement of a separating apparatus according to the third embodiment. A separating apparatus 400 of the third embodiment has a separating apparatus 200 shown in Figs. 3 and 4 and press mechanisms 410 and 420.

The press mechanisms 410 and 420 have limiting members 401 and 402 for limiting the warp amount of the bonded substrate stack 101 during separation processing, respectively. Each of the limiting members 401 and 402 has, e.g., a disk shape. The limiting members 401 and 402 are driven by air cylinders 405 and 406, respectively. The driving forces (press forces) generated by the air cylinders 405 and 406 are preferably gradually or stepwise increased as separation of the bonded substrate stack 101 progresses. Assume that the pressure to be applied to an enclosed space 210 in separation processing is 20 kgf/cm$^2$. At the early stage of separation, the bonded substrate stack 101 is not pressed. In accordance with progress of separation, the press force is gradually increased. At the final stage of separation, the press force is preferably 19 kgf/cm$^2$.

The processing procedure for separating the bonded substrate stack 101 by the separating apparatus 400 will be described below. Separation processing is performed under, e.g., the atmospheric pressure.

First, a substrate supporting member 202 is unlocked by a lock mechanism 207 and opened, as shown in Fig. 4. The bonded substrate stack 101 is placed on a substrate supporting member 201. As shown in Fig. 3, the substrate supporting member 202 is closed and locked by the lock mechanism 207. In this state, the enclosed space 210 is formed around the side surface portion of the bonded substrate stack 101 where a porous layer 101b is exposed.

The air cylinders 405 and 406 retract pistons 403 and 404, respectively, to separate the limiting members 401 and 402 from each other. The separating apparatus 200 is set between the limiting members 401 and 402. The air cylinders 405 and 406 extend the pistons 403 and 404 to bring the limiting members 401 and 402 into contact with the bonded substrate stack 101, respectively. In this state, the separating apparatus 200 is supported by the limiting member 402 positioned on the lower side of the apparatus.

A fluid is injected into the enclosed space 210 by a pressure source 220. Pressure is applied to the fluid in the enclosed space 210 by the pressure source 220. The pressure of the fluid substantially standing still is applied to the porous layer 101b exposed to the edge of the bonded substrate stack 101.

Separation starts as the applied pressure breaks the porous layer 101b exposed to the edge of the bonded substrate stack 101. When the fluid is injected into the broken portion, break of the porous layer 101b progresses. As break of the porous layer 101b progresses, the fluid is sufficiently injected into the bonded substrate stack 101. At this time, due to the difference between the pressure of the fluid acting on the interior of the bonded substrate stack 101 and that acting on the unclosed space (space other than the enclosed space), a separation force acts on the bonded substrate stack 101 to separate substrates 101a and 101c. The substrates 101a and 101c warp due to this separation force. The warp amount is limited by the press forces of the limiting members 401 and 402.

When separation is ended, the pressure source 220 is controlled to set the enclosed space 210 at the atmospheric pressure. The air cylinders 405 and 406 retract the pistons 403 and 404 to separate the limiting members 401 and 402 from each other, respectively. Next, the substrate supporting member 202 is unlocked by the lock mechanism 207 and opened. The separated substrates 101a and 101c are extracted.

[Fourth Embodiment]

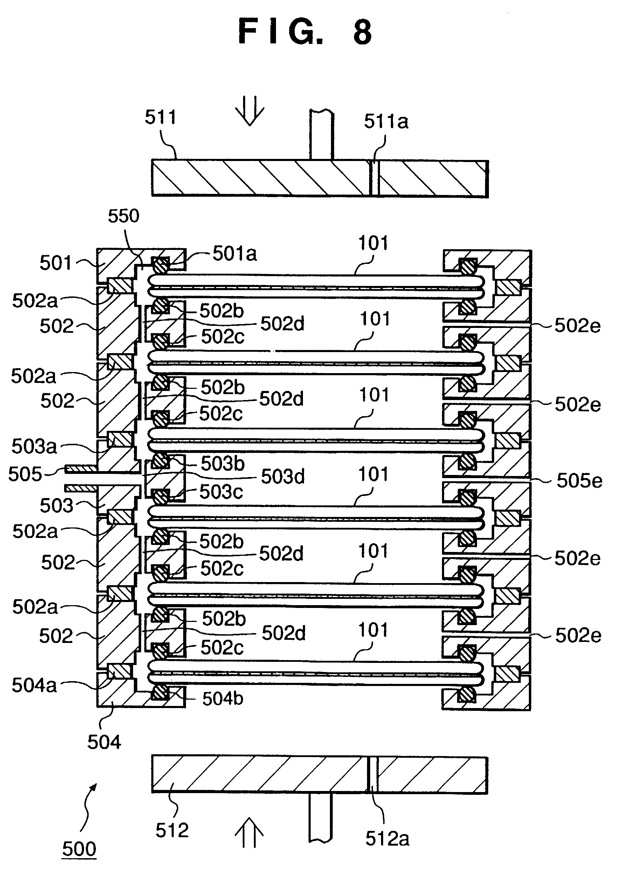

The fourth embodiment is related to a separating apparatus capable of batch separation of a plurality of bonded substrate stacks 101. Fig. 8 is a sectional view showing the arrangement of the separating apparatus according to the fourth embodiment.

In a separating apparatus 500, a plurality of bonded substrate stacks 101 are supported by a first substrate supporting member 501, one or a plurality of second substrate supporting members 502, a third substrate supporting member 503, and a fourth substrate supporting member 504. The substrate support comprising the first to fourth substrate supporting members 501 to 504 are pressed by press mechanisms 511 and 512 from both sides.

Each of the first to fourth substrate supporting members 501 to 504 has an annular shape conforming to the side surface of the bonded substrate stack 101. The first substrate supporting member 501 has an annular sealing member 501a for ensuring airtightness between the member 501 and the bonded substrate stack 101. The first substrate supporting member 501 constitutes one end of the substrate support formed from the first to fourth substrate supporting members 501 to 504. Each second substrate supporting member 502 has, on both sides, annular sealing members 502b and 502c for ensuring airtightness between the member 502 and the bonded substrate stack 101. The second substrate supporting member 502 also has, on the outer peripheral side, a sealing member 502a for ensuring airtightness between the member 502 and another substrate supporting member. The third substrate supporting member 503 has, on both sides, annular sealing members 503b and 503c for ensuring airtightness between the member 503 and the bonded substrate stack 101. The third substrate supporting member 503 also has, on the outer peripheral side, a sealing member 503a for ensuring airtightness between the member 503 and another substrate supporting member. The fourth substrate supporting member 504 has, on one side, an annular sealing member 504b for ensuring airtightness between the member 504 and the bonded substrate stack 101. The fourth substrate supporting member 504 also has, on the outer peripheral side, a sealing member 504a for ensuring airtightness between the member 504 and another substrate supporting member. The fourth substrate supporting member 504 constitutes the other end of the substrate support formed from the first to fourth substrate supporting members 501 to 504.

The third substrate supporting member 503 has an injection portion 505 for injecting a fluid into an enclosed space 550 formed, by the first to fourth substrate supporting members 501 to 504, around the edge portion of each bonded substrate stack 101 where a porous layer 101b is exposed. The third substrate supporting member 503 has a hole 503d through which the enclosed spaces formed on both sides of the member 503 spatially communicate with each other. The second substrate supporting member 502 also has a hole 502d through which the enclosed spaces formed on both sides of the member 502 spatially communicate with each other. With this arrangement, the enclosed space 550 formed by the first to fourth substrate supporting members 501 to 504 is spatially connected to the injection portion 505.

The second and third substrate supporting members 502 and 503 have vent holes 502e and 503e for connecting each space sandwiched by two bonded substrate stacks 101 to the external space, respectively.

The injection portion 505 is connected to a pressure source (not shown) such as a pump. The enclosed space 550 is filled with the fluid (e.g., water) supplied from the pressure source. The pressure source preferably has a mechanism for adjusting the pressure to be applied to the fluid. With this mechanism, the pressure to be applied to the fluid is preferably set to be high at the early stage of separation of the bonded substrate stack 101 and then gradually or stepwise reduced. For example, at the early stage of separation, the pressure is set at, e.g., 20 kg/cm$^2$ and then gradually reduced to, e.g., 1 kg/cm$^2$ at the final stage of separation.

In the separating apparatus 500, the number of bonded substrate stacks 101 to be processed can be changed by changing the number of second substrate supporting members 502. For example, when one second substrate supporting member 502, one first substrate supporting member 501, one third substrate supporting member 503, and one fourth substrate supporting member 504 are used, three bonded substrate stacks 101 can be simultaneously processed. When one first substrate supporting member 501, one third substrate supporting member 503, and one fourth substrate supporting member 504 are used without using any second substrate supporting member 502, two bonded substrate stacks 101 can be simultaneously processed.

The press mechanisms 511 and 512 correspond to the lock mechanism in the first to third embodiments. More specifically, when the substrate support formed from the first to fourth substrate supporting members 501 to 504 sandwiching and supporting a plurality of bonded substrate stacks 101 is pressed by the press mechanisms 511 and 512 from both sides, the substrate support can be fixed. The press mechanisms 511 and 512 have vent holes 511a and 512a for connecting the spaces inside the bonded substrate stacks 101 to the external space.

The processing procedure for separating the bonded substrate stacks 101 by the separating apparatus 500 will be described below. Separation processing is performed under, e.g., the atmospheric pressure.

The first to fourth substrate supporting members 501 to 504 are prepared. The first, second, third, and fourth substrate supporting members are stacked in this order, and the bonded substrate stacks 101 are set between the substrate supporting members. As described above, when only two bonded substrate stacks 101 are to be simultaneously processed, the second substrate supporting members 502 can be omitted.

The substrate support formed from the first to fourth substrate supporting members 501 to 504 is pressed and held by the press mechanisms 511 and 512 from both sides. The enclosed space 550 is formed around the edge portion of each bonded substrate stack 101 where the porous layer 101b is exposed.

A fluid is injected into the enclosed space 550 by the pressure source (not shown) connected to the injection portion 505. Pressure is applied to the fluid in the enclosed space 550 by the pressure source. The pressure of the fluid substantially standing still is applied to the porous layer 101b exposed to the edge of each bonded substrate stack 101.

Separation starts as the applied pressure breaks the porous layer 101b exposed to the side surface portion of each bonded substrate stack 101. When the fluid is injected into the broken portion, break of the porous layer 101b progresses. As break of the porous layer 101b progresses, the fluid is sufficiently injected into each bonded substrate stack 101. At this time, due to the difference between the pressure of the fluid acting on the interior of the bonded substrate stack 101 and that acting on the unclosed space (space other than the enclosed space), a separation force acts on each bonded substrate stack 101 to separate substrates 101a and 101c. Separation progresses with this separation force.

When separation is ended, the pressure source is controlled to set the enclosed space 550 at the atmospheric pressure. After this, pressing by the press mechanisms 511 and 512 is canceled. The first to fourth substrate supporting members 501 to 504 are deassembled. The separated substrates 101a and 101c are extracted.

[Application Examples of Separating Apparatus]

Application examples of the separating apparatuses according to the first to fourth embodiments will be described below.

[Application Example 1]

A p- or n-type first single-crystal Si substrate (11 in Fig. 1A) having a resistivity of 0.01 ($\Omega$·cm) was anodized in an HF solution to form a porous Si layer (12 in Fig. 1A) on the surface of the substrate. The anodizing conditions were as follows.

　　　Current density: 7 (mA·cm$^{-2}$)
　　　Anodizing solution: HF: $H_2O$ : $C_2H_5OH$ = 1 : 1 : 1
　　　Time: 11 (min)
　　　Thickness of porous Si layer: 12 ($\mu$m)

The porous Si layer was used as a layer on which a high-quality epitaxial Si layer is to be formed, and as a separation layer after the substrate was bonded to the second substrate. That is, in this application example, the porous Si layer was used for the two purposes.

The thickness of the porous Si layer is not limited to the above example and is preferably, e.g., several hundred to 0.1 $\mu$m.

The substrate was oxidized in an oxygen atmosphere at, e.g., 400°C for 1 hr. Upon this oxidation, the inner walls of pores in the porous Si layer were covered with thermal oxide films.

The surface of the porous Si layer of this substrate was processed with an HF solution to remove only the oxide film on the surface of the porous Si layer while leaving the oxide films on the inner walls of the pores. After this, a 0.3-$\mu$m thick single-crystal Si layer (13 in Fig. 1B) was epitaxially grown on the porous Si layer by CVD (Chemical Vapor Deposition). The growth conditions were as follows.

　　　Source gas: $SiH_2Cl_2/H_2$
　　　Gas flow rate: 0.5/180 (l/min)
　　　Gas pressure: 80 (Torr)
　　　Temperature: 950 (°C)
　　　Growth rate: 0.3 ($\mu$m/min)

A 200-nm thick oxide film ($SiO_2$ layer) as an insulating layer (15 in Fig. 1B) was formed on the surface of the epitaxial layer by thermal oxidation.

The surface of the $SiO_2$ layer was overlaid on the surface of an independently prepared second Si substrate (20 in Fig. 1C). After the substrates came into contact with each other, the substrates were bonded by annealing at, e.g., 1,100°C for 1 hr.

The bonded substrate stack formed by the above process was separated at the porous Si layer using one of the separating apparatuses of the first to fourth embodiments. An example will be described. The pressure to be applied to the porous Si layer of the bonded substrate stack is preferably set at, e.g., 20 kg/cm$^2$ at the early stage of separation and then gradually reduced to, e.g., 1 kg/cm$^2$ at the final stage of separation.

With this separation, the $SiO_2$ layer, epitaxial Si layer, and part of the porous Si layer, which were formed on the surface of the first substrate, were transferred to the second substrate side. Only the porous Si layer remained on the surface of the first substrate.

The porous Si layer transferred onto the second substrate was selectively etched using a mixed solution of 49% hydrofluoric acid and 30% hydrogen peroxide while stirring the solution. At this time, the underlying single-crystal Si layer functioned as an etching stopper. The overlying porous Si layer was selectively etched and completely removed.

The etching rate of non-porous single-crystal Si by the etchant is very low, and the selectivity ratio between the porous Si layer and the non-porous Si layer reaches 10$^5$ or more. The etching amount (about several ten angstrom) of the non-porous Si layer can be neglected in practical use.

With the above process, an SOI substrate having a 0.2-$\mu$m thick single-crystal Si layer on the $SiO_2$ layer could be formed.

When the surface of the resultant SOI substrate was observed with an atomic force microscope (AFM) for any microscopic structure, smoothness at the atomic level was obtained. The single-crystal Si layer stayed the same even after selective etching of the porous Si layer. The film thickness of the single-crystal Si layer of this SOI substrate was measured at 100 points on the entire surface. The film thickness uniformity was 201 nm ± 4 nm. Section observation with a transmission electron microscope showed no new crystal defects in the single-crystal Si layer, indicating that satisfactory crystallinity was maintained. The resultant structure was annealed in a hydrogen atmosphere at 1,100°C for 1 hr, and the surface roughness was evaluated with an atomic force microscope. The mean square roughness in a 50-$\mu$m square area was approximately 0.2 nm. This nearly equals that of a commercially available Si wafer.

The same result as described above can be obtained even when the oxide film is formed not on the surface of the epitaxial layer but on the surface of the second substrate, or on both surfaces.

The porous Si layer left on the first substrate side is selectively etched using, e.g., a mixed solution of 40% hydrofluoric acid and 30% hydrogen peroxide. After this, a surface treatment such as hydrogen annealing or surface polishing is performed. With this process, the substrate can be reused as the first or second substrate.

[Application Example 2]

A p- or n-type first single-crystal Si substrate (11 in Fig. 1A) having a resistivity of 0.01 ($\Omega$·cm) was anodized in two steps in an HF solution to form two porous Si layers (12 in Fig. 1A). The anodizing conditions were as follows.

First step
　　Current density: 7 (mA·cm$^{-2}$)
　　Anodizing solution: HF : H$_2$O : C$_2$H$_5$OH = 1 : 1 : 1
　　Time: 10 (min)
　　Thickness of porous Si layer: 12 ($\mu$m)
Second step
　　Current density: 20 (mA·cm$^{-2}$)
　　Anodizing solution: HF : H$_2$O : C$_2$H$_5$OH = 1 : 1 : 1
　　Time: 2 (min)
　　Thickness of porous Si layer: 3 ($\mu$m)

Of the two porous Si layers, the porous Si layer as a surface layer formed by anodizing of the first step at the low current density can be used as a layer on which a high-quality epitaxial layer is to be formed. The underlying porous Si layer formed by anodizing of the second step at the high current density can be used as a separation layer. The thickness of the porous Si layer formed at the low current density is not limited to the above example and is preferably, e.g., several hundred to 0.1 $\mu$m. The porous Si layer formed at the high current density is not limited to the above example, either, and various thicknesses can be employed. A third or more porous Si layers may be formed after formation of the second porous Si layer.

The substrate was oxidized in an oxygen atmosphere at, e.g., 400°C for 1 hr. Upon this oxidation, the inner walls of pores in the porous Si layer were covered with thermal oxide films.

The surface of the porous Si layer of this substrate was processed with an HF solution to remove only the oxide film on the surface of the porous Si layer while leaving the oxide films on the inner walls of the pores. After this, a 0.3-$\mu$m thick single-crystal Si layer was epitaxially grown on the porous Si layer by CVD (Chemical Vapor Deposition). The growth conditions were as follows.

　　Source gas: SiH$_2$Cl$_2$/H$_2$

　　Gas flow rate: 0.5/180 (l/min)
　　Gas pressure: 80 (Torr)
　　Temperature: 950 (°C)
　　Growth rate: 0.3 ($\mu$m/min)

A 200-nm thick oxide film (SiO$_2$ layer) as an insulating layer (15 in Fig. 1B) was formed on the surface of the epitaxial layer by thermal oxidation.

The surface of the SiO$_2$ layer was overlaid on the surface of an independently prepared second Si substrate (20 in Fig. 1C). After the substrates came into contact with each other, the substrates were bonded by annealing at, e.g., 1,180°C for 5 min.

The bonded substrate stack formed by the above process was separated at the porous Si layer using one of the separating apparatuses of the first to fourth embodiments. An example will be described. The pressure to be applied to the porous Si layer of the bonded substrate stack is preferably set at, e.g., 20 kg/cm$^2$ at the early stage of separation and then gradually reduced to, e.g., 1 kg/cm$^2$ at the final stage of separation.

With this separation, the SiO$_2$ layer, epitaxial Si layer, and part of the porous Si layer, which were formed on the surface of the first substrate, were transferred to the second substrate side. Only the porous Si layer remained on the surface of the first substrate.

The porous Si layer transferred onto the second substrate was selectively etched using a mixed solution of 49% hydrofluoric acid and 30% hydrogen peroxide while stirring the solution. At this time, the single-crystal Si layer functioned as an etching stopper. The overlying porous Si layer was selectively etched and completely removed.

The etching rate of non-porous single-crystal Si by the etchant is very low, and the selectivity ratio between the porous Si layer and the non-porous Si layer reaches 10$^5$ or more. The etching amount (about several ten angstrom) of the non-porous Si layer can be neglected in practical use.

With the above process, an SOI substrate having a 0.2-$\mu$m thick single-crystal Si layer on the SiO$_2$ layer could be formed.

When the surface of the resultant SOI substrate was observed with an atomic force microscope (AFM) for any microscopic structure, smoothness at the atomic level was obtained. The single-crystal Si layer stayed the same even after selective etching of the porous Si layer. The film thickness of the single-crystal Si layer of this SOI substrate was measured at 100 points on the entire surface. The film thickness uniformity was 201 nm $\pm$ 4 nm. Section observation with a transmission electron microscope revealed no new crystal defects in the single-crystal Si layer, indicating that satisfactory crystallinity was maintained. The resultant structure was annealed in a hydrogen atmosphere at 1,100°C for 1 hr, and the surface roughness was evaluated with an atomic force microscope. The mean square roughness in a 50-$\mu$m square area was approximately 0.2 nm. This nearly equals that of a commercially available Si wafer.

The same result as described above can be obtained even when the oxide film is formed not on the surface of the epitaxial layer but on the surface of the second substrate, or on both surfaces.

The porous Si layer left on the surface of the first substrate is selectively etched using, e.g., a mixed solution of 40% hydrofluoric acid and 30% hydrogen peroxide. After this, a surface treatment such as hydrogen annealing or surface polishing is performed. With this process, the substrate can be reused as the first or second substrate.

[Application Example 3]

A 200-nm thick oxide ($SiO_2$) layer as an insulating layer was formed on the surface of the first single-crystal Si substrate by thermal oxidation.

Under a condition for setting the projection range in the Si substrate, ions were implanted from the surface into the first substrate. A layer functioning as a separation layer was formed at the depth of projection range as a microcavity layer or a distortion layer due to the heavily-doped ion-species-implanted layer.

The surface of the $SiO_2$ layer was overlaid on the surface of an independently prepared second Si substrate. After the substrates came into contact with each other, the substrates were bonded by annealing at, e.g., 600°C for 10 hrs. When the substrates are processed by $N_2$ plasma processing before bonding, the bonding strength can be increased.

The bonded substrate stack formed by the above process was separated at the porous Si layer using one of the separating apparatuses of the first to fourth embodiments. An example will be described. The pressure to be applied to the porous Si layer of the bonded substrate stack is preferably set at, e.g., 20 kg/cm$^2$ at the early stage of separation and then gradually reduced to, e.g., 1 kg/cm$^2$ at the final stage of separation.

With this separation, the $SiO_2$ layer, underlying single-crystal layer, and part of the separation layer, which were formed on the surface of the first substrate, were transferred to the second substrate side. The remaining portion of the separation layer remained on the surface of the first substrate.

The separation layer transferred to the second substrate side was selectively etched using a mixed solution of 49% hydrofluoric acid and 30% hydrogen peroxide while stirring the solution. At this time, the single-crystal Si layer functioned as an etching stopper. The overlying separation layer was selectively etched and completely removed. When the remaining separation layer is sufficiently thin, this etching process may be omitted. The remaining separation layer may be removed by CMP (Chemical Mechanical Polishing).

With the above process, an SOI substrate having a 0.2-μm thick single-crystal Si layer on the $SiO_2$ layer could be formed.

The film thickness of the single-crystal Si layer of this SOI substrate was measured at 100 points on the entire surface. The film thickness uniformity was 201 nm ± 4 nm. Section observation with a transmission electron microscope showed no new crystal defects in the single-crystal Si layer, indicating that satisfactory crystallinity was maintained. The resultant structure was annealed in a hydrogen atmosphere at 1,100°C for 1 hr, and the surface roughness was evaluated with an atomic force microscope. The mean square roughness in a 50-μm square area was approximately 0.2 nm. This nearly equals that of a commercially available Si wafer.

The same result as described above can be obtained even when the oxide film is formed not on the surface of the epitaxial layer but on the surface of the second substrate, or on both surfaces.

The separation layer left on the first substrate side can also be removed by CMP. After this, a surface treatment such as hydrogen annealing or surface polishing is performed. With this process, the substrate can be reused as the first or second substrate.

In this application example, the separation layer was formed by implanting ions into the lower layer of the surface region of the single-crystal Si wafer, the wafer was bonded to the second substrate, and the two substrates were separated at the separation layer, thereby transferring the surface region of the single-crystal Si wafer to the second substrate. An epitaxial wafer may be used as the first substrate, and the epitaxial layer may be transferred to the second substrate in the same way as described above.

The above application example may be modified as follows. After the separation layer is formed by implanting ions into the first substrate, the $SiO_2$ layer on the surface is removed. An epitaxial layer is formed on the surface, and an $SiO_2$ layer is further formed on the epitaxial layer. After the substrate is bonded to the second substrate, the two substrates are be separated at the separation layer. In this case, the epitaxial layer formed on the first substrate and the actual surface region underneath the epitaxial layer are transferred to the second substrate.

[Application Example 4]

An SOI substrate can be manufactured following the same procedures as in the second application example using a transparent substrate (e.g., silica substrate) as the second substrate. In this case, the process is preferably changed as follows.

1) Before the first and second substrates are bonded, $N_2$ plasma processing is performed.
2) The time of annealing at 400°C is changed from 1 hr to about 100 hrs.
3) The temperature of annealing (surface planarization for the SOI layer) in the hydrogen atmosphere is changed to 1,000°C or less (e.g., at 970°C for 4 hrs).

When a transparent substrate formed from an insulating material is used as the second substrate, the oxide film (insulating layer) on the surface of the epitaxial layer or on the surface of the second substrate in the first to third application examples is not always necessary. However, the oxide film (insulating layer) is preferably formed to minimize the influence of an impurity that may stick to the interface by separating, from the bonding interface, the epitaxial layer on which an element such as a transistor is to be formed later.

According to the present invention, an apparatus and method suitable to separate a sample (member) such as a bonded substrate stack can be provided.

[Second Mode]

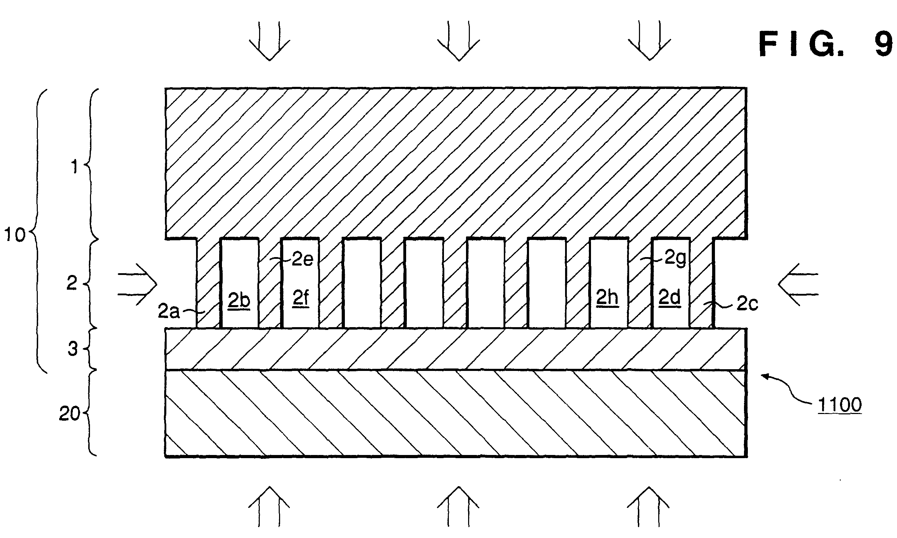

Figs. 9 to 11 are views schematically showing a sample (member) separating method according to the second mode of the present invention. A sample 1100 to be separated has a cavity-containing layer (porous layer) 2 having a fragile structure. An example wherein the cavity-containing layer 2 has cavity walls (walls partitioning cavities) substantially perpendicular to the sample surface, as shown in Fig. 9, will be described. The cavity-containing layer 2 is formed by, e.g., anodizing a single-crystal Si substrate in an HF solution.

The sample separating method of the second mode is suitable for separating, at the cavity-containing layer 2, a sample (bonded substrate stack) formed by bonding a first substrate 10 having the cavity-containing layer 2 on a main body substrate 1 and a non-cavity-containing layer 3 on the cavity-containing layer 2 and a second substrate 20 via the non-cavity-containing layer 3. With this separation processing, the non-cavity-containing layer 3 on the surface of the first substrate 10 can be transferred to the surface of the second substrate 20.

As the non-cavity-containing layer 3, for example, 1) a single-crystal Si layer, 2) a polysilicon layer, 3) an amorphous Si layer, 4) a metal film, 5) a compound semiconductor film, 6) a superconducting thin film, 7) a layer containing a semiconductor element (e.g., a transistor, a light-emitting element, or a solar cell), or 8) a layer with a multilayered structure having an insulating layer (e.g., $SiO_2$ layer) on one of the above layers is preferably used. As the second substrate 20, for example, 1) a single-crystal Si substrate, 2) a substrate having an insulating layer (e.g., $SiO_2$ layer) on a single-crystal Si substrate, 3) a transparent substrate (e.g., silica substrate), 4) a sapphire substrate, 5) a substrate formed from an insulating material, or 6) a resin substrate (e.g., a card having an IC to form an IC card) is preferably used.

In the second mode, the sample 1100 is set in a high-pressure environment to generate a pressure difference between the interior and exterior of a cavity in the cavity-containing layer 2. The cavity walls (cavity-containing layer 2) break due to the pressure difference to separate the sample 1100 into two parts.

The medium (fluid) for applying pressure to the sample may be either a liquid such as water or a gas such as air. Not only the pressure of the fluid but also a mechanical force may be applied to the cavity-containing layer 2. To apply a mechanical force to the cavity-containing layer 2, a knife- or wedge-like inserting member is preferably inserted into the cavity-containing layer 2.

The pressure of the fluid is preferably applied to the entire sample 1100. This makes it possible to efficiently apply the breaking force to the cavity-containing layer 2. To do this, preferably, the entire sample 1100 is accommodated in a closed vessel and the pressure is applied into the closed vessel. In this case, the pressure of the fluid isotropically acts on various portions of the sample 1100. Referring to Figs. 9 to 11, arrows schematically indicate the pressure applied to the sample 1100.

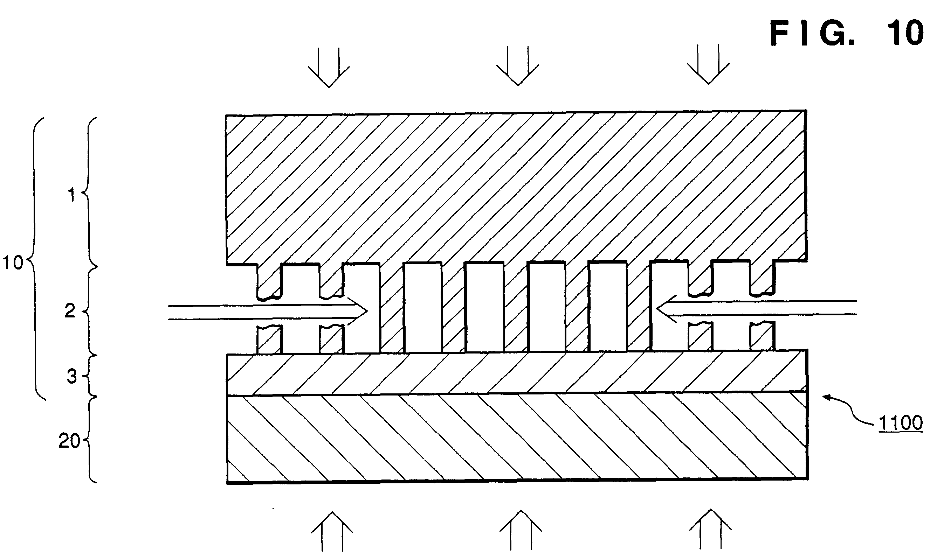

Fig. 9 is a view schematically showing the early stage of sample separation processing using pressure. At this stage, the pressure difference between the external pressure and the internal pressure of cavities 2b and 2d inside cavity walls 2a and 2c acts on the cavity walls 2a and 2c exposed to the end portions of the cavity-containing layer 2 in the sample 1100, so the cavity walls 2a and 2c break. When the cavity walls 2a and 2c break, the cavities 2b and 2d communicate with the external space. For this reason, the external pressure acts on the spaces of the cavities 2b and 2d. The pressure difference between the external pressure and the internal pressure of cavities 2f and 2h inside cavity walls 2e and 2g acts on the cavity walls 2e and 2g, so the cavity walls 2e and 2g break. Fig. 10 schematically shows a state wherein the cavity walls 2a, 2c, 2e, and 2g have broken.

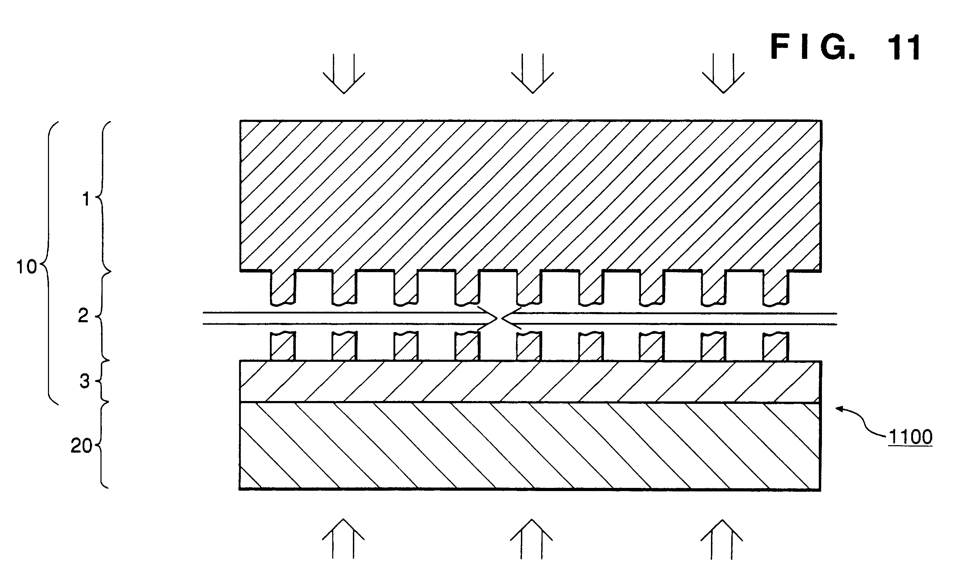

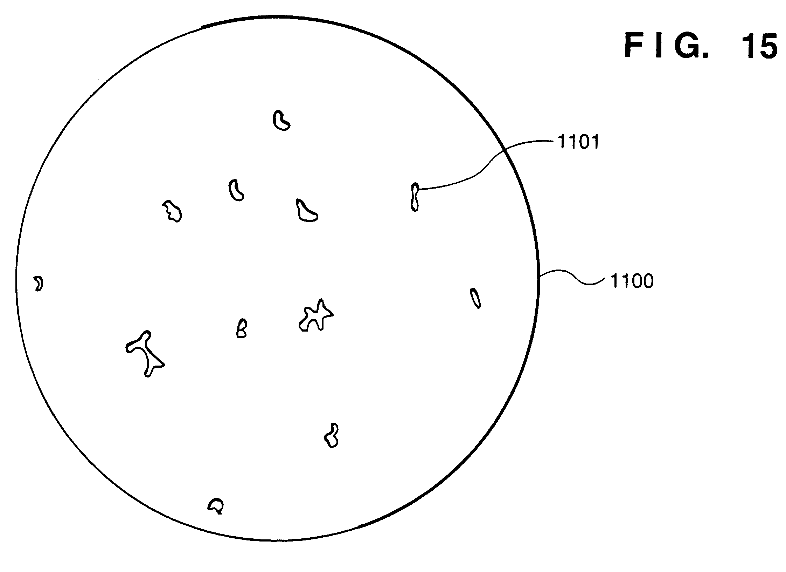

When processing progresses, finally, the cavity walls at the central portion of the cavity-containing layer 2 break, as shown in Fig. 11. However, all cavity walls in the cavity-containing layer 2 may not always break. Some cavity walls may remain intact because no force is inflicted upon them. Fig. 15 schematically shows a sample in which the cavity walls in the cavity-containing layer 2 have not completely broken. Fig. 15 is a sectional view of the cavity-containing layer 2 of the sample 1100 in the planar direction. Referring to Fig. 15, reference numeral 1101 denotes a cavity wall that has not broken.

To break all cavity walls in the cavity-containing layer 2, after separation processing using the pressure (first separation processing), the second separation processing is applied. Most cavity walls have broken by the separating method using pressure, and the cavity-containing layer 2 has a more fragile structure. For this reason, in the second separation processing, the sample 1100 can be completely separated by applying a weak force to the sample 1100.

For example, the following techniques can be used for the second separation processing.

(1) A vibration energy such as an ultrasonic wave is applied to the sample.

(2) A tensile force or a press force is applied to the sample in a direction perpendicular to the surface (axial direction).

(3) A separating member (e.g., a knife-like member) is inserted into the cavity-containing layer 2.

(4) After the cavity-containing layer 2 is soaked with a liquid substance such as water, the bonded substrate stack is heated or cooled to increase the volume of the substance.

(5) A force is applied to the first substrate 10 or second substrate 20 in the planar direction.

(6) A jet of fluid is ejected toward the cavity-containing layer 2 (e.g., the water jet method).

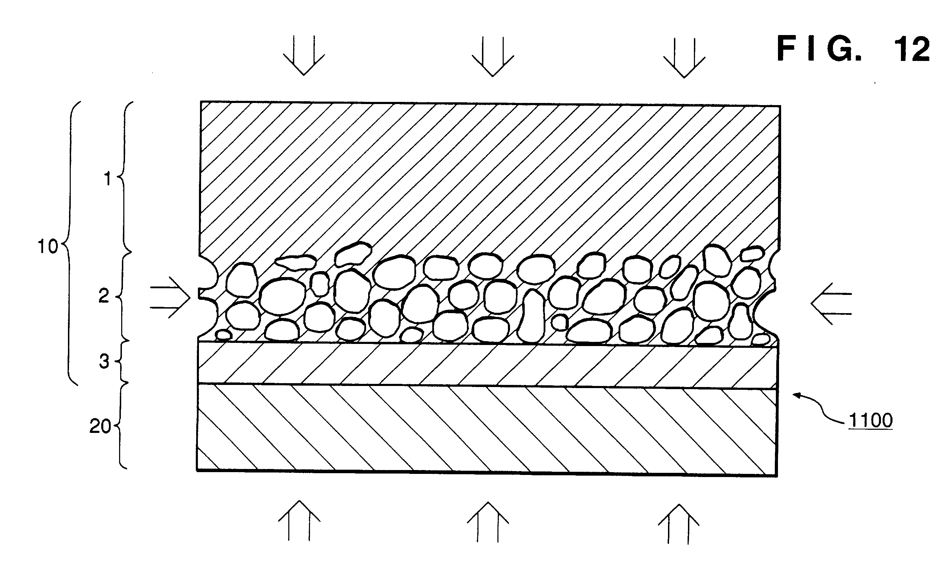

Figs. 12 to 14 are views schematically showing a method of separating a sample having a cavity-containing layer with another structure. In the example shown in Figs. 12 to 14, the cavity-containing layer 2 has a number of bubble-like cavities. This cavity-containing layer 2 is formed by implanting ions of at least one element selected from, e.g., a rare gas, hydrogen, and nitrogen into a single-crystal Si substrate and then annealing the single-crystal Si substrate as needed. The resultant cavities are also called microcavities. The layer having microcavities is also called a microcavity layer.

As the sample 1100 shown in Figs. 12 to 15, a sample (bonded substrate stack) formed by bonding the first substrate 10 and second substrate 20 is preferably used. In this case, the first substrate 10 has the cavity-containing layer (microcavity layer) 2 under the non-cavity-containing layer 3, which is formed by implanting ions of at least one element selected from, e.g., a rare gas, hydrogen, and nitrogen into the main body substrate 1 such as a single-crystal Si substrate and then annealing the main body substrate 1 as needed.

The non-cavity-containing layer 3 preferably comprises, e.g., 1) a single-crystal Si layer, 2) a polysilicon layer, 3) an amorphous Si layer, 4) a metal film, 5) a compound semiconductor film, 6) a superconducting thin film, 7) a layer containing a semiconductor element (e.g., a transistor, a light-emitting element, or a solar cell), or 8) a layer with a multilayered structure having an insulating layer (e.g., $SiO_2$ layer) on one of the above layers. As the second substrate 20, for example, 1) a single-crystal Si substrate, 2) a substrate having an insulating layer (e.g., $SiO_2$ layer) on a single-crystal Si substrate, 3) a transparent substrate (e.g., silica substrate), 4) a substrate formed from an insulating material, or 5) a resin substrate (e.g., a card having an IC to form an IC card) is preferably used.

The sample 1100 shown in Figs. 12 to 15 can also be separated by separation processing using a pressure and the second separation processing, which are described above with reference to Figs. 9 to 11.

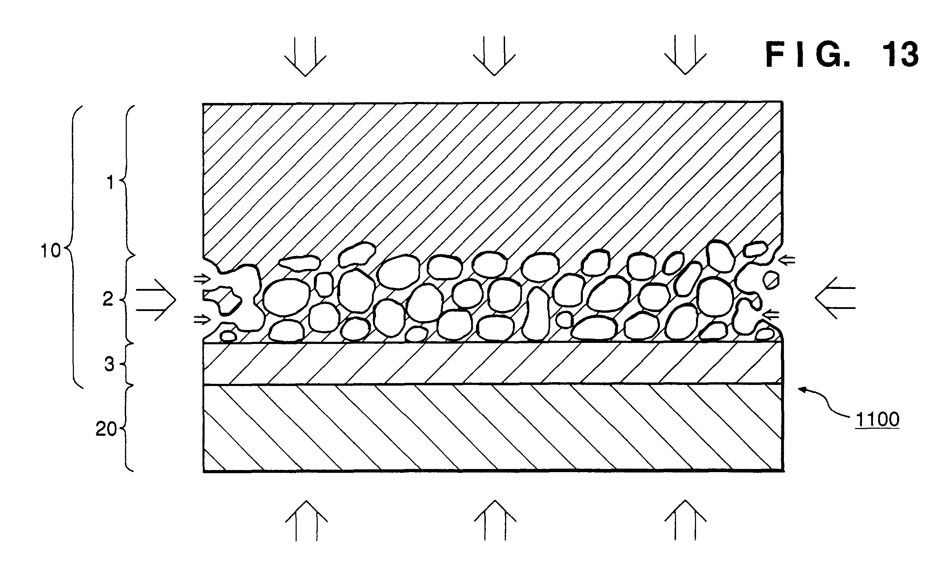

Fig. 12 is a view schematically showing the early stage of sample separation processing using pressure. At this stage, the pressure difference between the external pressure and the pressure inside cavity walls (in cavities) acts on the cavity walls exposed to the end portions of the cavity-containing layer 2 in the sample 1100, so the cavity walls break. When the cavity walls break, cavities partitioned by the cavity walls communicate with the external space. As cavity walls inside break further, break of the cavity-containing layer 2 progresses. Fig. 13 shows the middle stage of sample separation processing using a pressure.

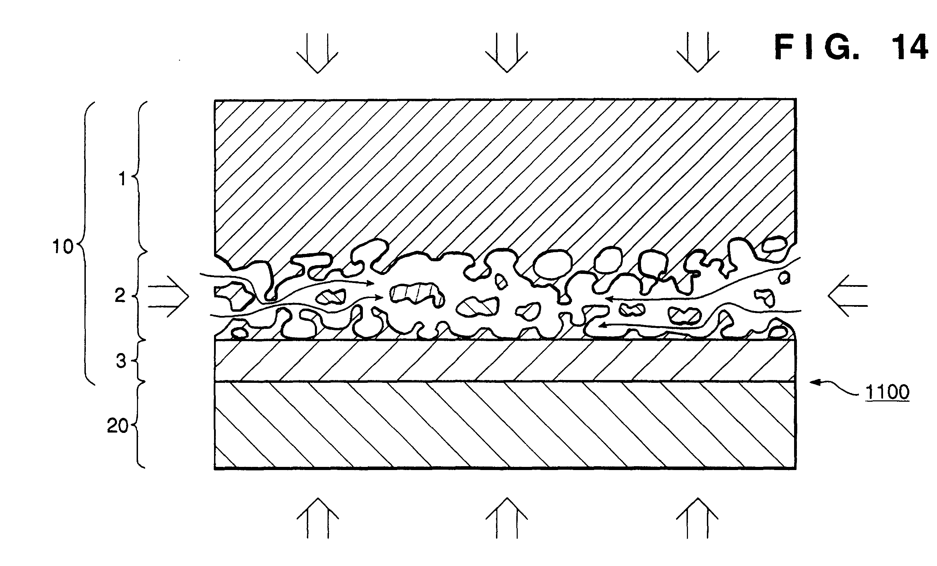

The above processing progresses, and finally, the cavity walls at the central portion of the cavity-containing layer 2 break, as shown in Fig. 14. In the example shown in Figs. 11 to 14 as well, all cavity walls in the cavity-containing layer 2 may not always break. As shown in Fig. 15, some cavity walls may remain intact because no force acts on them. In this case, the sample 1100 can be completely separated using the above-described second separation processing.

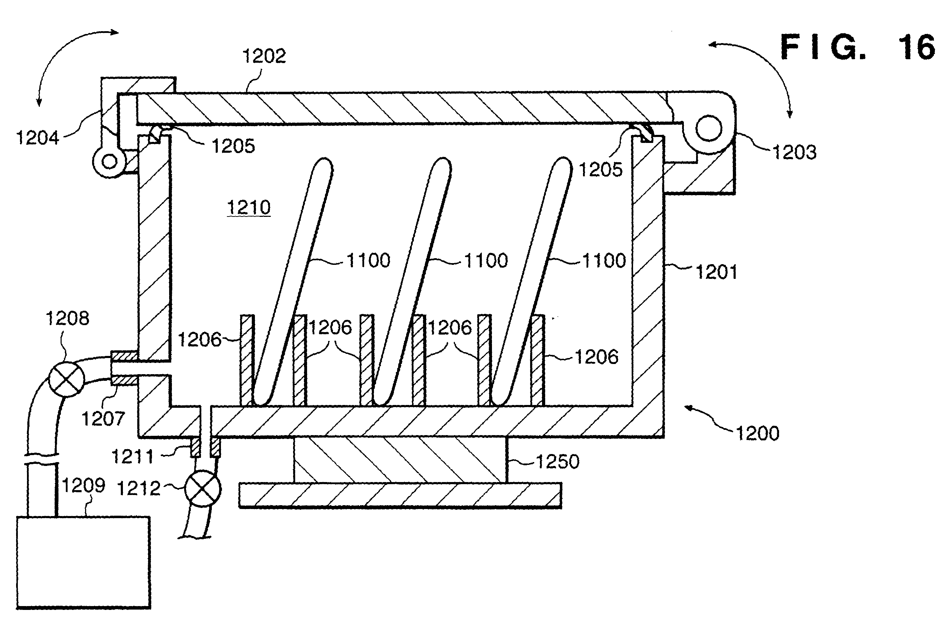

Fig. 16 is a view schematically showing the arrangement of a sample separating apparatus according to the second mode of the present invention. A separating apparatus 1200 is used to perform the above-described first separation processing, i.e., sample separation processing using pressure.

This separating apparatus 1200 has a closed vessel 1201 for storing the sample 1100 and forming an enclosed space 1210, and a closing lid 1202. The closed vessel 1201 and closing lid 1202 are coupled through a hinge portion 1203 such that the closing lid 1202 can be closed/opened. The separating apparatus 1200 also has a lock mechanism 1204 for locking the closing lid 1202 that is closed. The separating apparatus 1200 also has a sealing member 1205 for sealing the closed vessel 1201 and closing lid 1202.

The separating apparatus 1200 has an injection port 1207 for supplying a fluid into the enclosed space 1210. The injection port 1207 is connected to a pump 1209 through a valve 1208. The separating apparatus 1200 also has a discharge port 1211 for discharging the fluid in the closed vessel 1201. The discharge port 1211 is connected to a discharge control valve 1212.

The closed vessel 1201 has sample supporting members 1206 for supporting a plurality of samples 1100. Instead of preparing the sample supporting members 1206, for example, samples stored in a cassette (e.g., a wafer cassette) may be stored in the closed vessel 1201 and subjected to separation processing.

The separating apparatus 1200 preferably has a vibration source 1250 for applying a vibration energy such as an ultrasonic wave to the samples 1100. With this vibration source 1250, cavity walls that have not broken by separation processing using pressure (first separation processing) can be broken to completely separate the sample 1100 (second separation processing).

Separation processing using the separating apparatus 1200 will be described below. First, the closing lid 1202 is opened, and the samples 1100 to be processed are set in the closed vessel 1201 by, e.g., a conveyor robot. The samples 1100 are supported upright by the sample supporting members 1206. As described above, a cassette storing one or a plurality of samples may be stored in the closed vessel 1201.

The closing lid 1202 is closed and locked by the lock mechanism 1204. The pump 1209 is actuated, and the valve 1208 is opened to inject a fluid into the enclosed space 1210. The internal pressure of the enclosed space 1210 is set at a predetermined pressure (start of the first separation processing). As the fluid, a gas such as air or a liquid such as water can be used. As the fluid, an etching gas or etchant capable of selectively etching the cavity-containing layer may be used. In this case, separation processing can be efficiently performed, and the number of cavity walls that may remain after separation can be decreased.

In this state, processing waits for, e.g., a predetermined time. Each sample 1100 is completely separated at the cavity-containing layer, or most cavity walls break. Next, the pump 1209 is stopped, and the valve 1208 is closed. The valve 1212 is opened to discharge the fluid in the enclosed space 1210 through the discharge port 1211, thereby returning the pressure in the enclosed space 1210 to the atmospheric pressure (end of the first separation processing). When a fluid that adversely affects the natural environment is used, the fluid discharged through the discharge port 1211 is recovered and appropriately processed.

The vibration source 1250 is driven to apply a vibration energy to the samples 1100 in the closed vessel 1201. With this process, unbroken cavity walls break, and the sample 1100 is completely separated (second separation processing). The second separation processing may be executed parallel to the first separation processing. Alternatively, the samples 1100 may be transferred to another apparatus to execute the second separation processing by another apparatus.

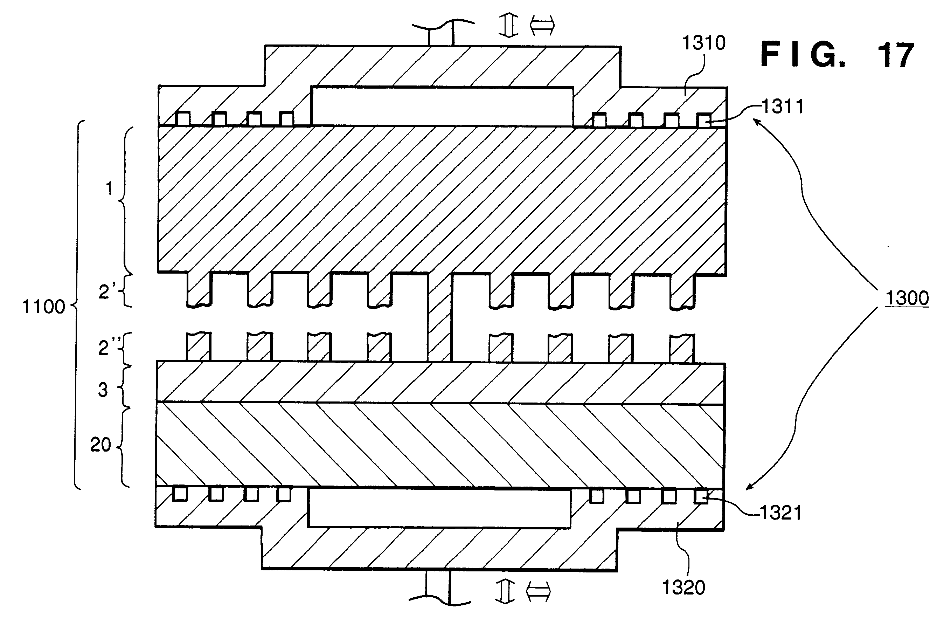

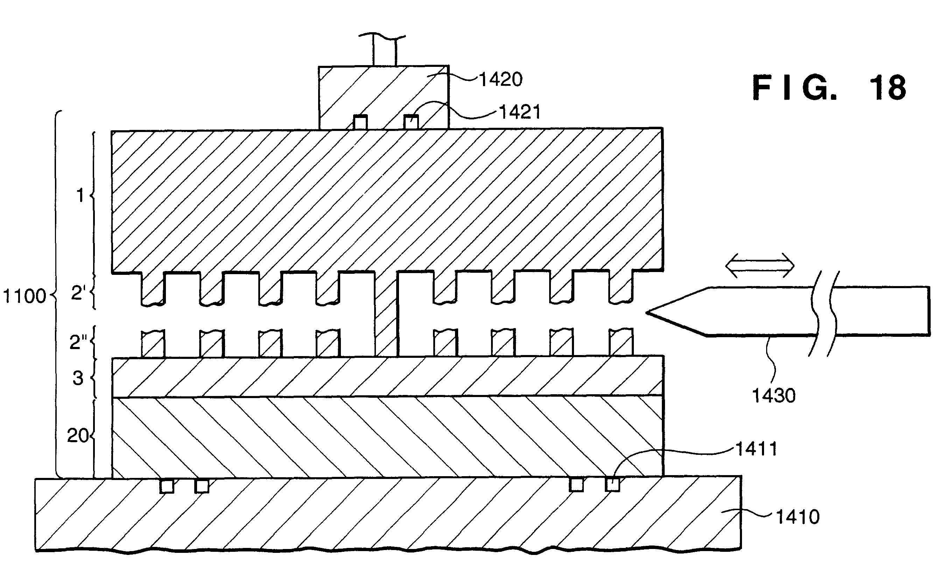

The closing lid 1202 is unlocked by the lock mechanism 1204 and opened. When a liquid is used as the fluid, the fluid in the enclosed space 1210 is discharged by opening the valve 1212, as needed. The processed samples 1100 are extracted from the enclosed space 1210 by, e.g., a conveyor robot. When separation processing is to be continued by another separating apparatus (e.g., a separating apparatus shown in Fig. 17 or 18) instead of the second separation processing using a vibration energy or in addition to the second separation processing, the extracted samples 1100 are transferred to another separating apparatus.

The separating apparatus 1200 shown in Fig. 16 batch-processes three samples 1100. The number of samples 1100 to be batch-processed is not limited to three.

According to the separating apparatus 1200, since the pressure difference is caused to selectively act on the cavity walls using the fact that the cavities in the cavity-containing layer are enclosed spaces, only the cavity walls can be selectively broken to separate the sample. Portions other than the cavity walls, i.e., the substrate main body 1, non-porous layer 3, and second substrate 20 do not break because the force based on the pressure difference rarely acts on these portions. Hence, the separating apparatus 1200 can separate the sample 1100 without damaging the portions other than the cavity-containing layer. According to the separating apparatus 1200, when the sample 1100 is formed by bonding the first and second substrates, no force capable of breaking the bond between the substrate acts on the bonding interface. For this reason, this apparatus is also suitable for separating a sample with a weak bond at the cavity-containing layer. Since this separating apparatus 1200 can batch-process a number of bonded substrate stacks, processing is efficient and a high throughput can be obtained.

Fig. 17 is a view schematically showing the arrangement of separation processing suitable to execute the second separation processing. A separating apparatus 1300 applies a tensile force or a press force to the sample 1100 in a direction (axial direction) perpendicular to the planar direction, or applies a force in the planar direction to completely separate the sample 1100. The separating apparatus 1300 has a pair of separation force application portions 1310 and 1320. The separation force application portions 1310 and 1320 have chuck mechanisms (e.g., vacuum chuck mechanisms or electrostatic chuck mechanisms) 1311 and 1321 for chucking the sample 1100, respectively. When the sample 1100 is to be separated by application of a press force, the chuck mechanisms 1311 and 1321 can be omitted.

Fig. 18 is a view schematically showing the arrangement of another separation processing suitable to execute the second separation processing. A separating apparatus 1400 has a pair of holding portions 1410 and 1420 for holding the sample 1100 and an inserting member 1430 to be inserted into the cavity-containing layer 2 (2' and 2"). The pair of holding portions 1410 and 1420 hold the sample 1100. In this state, the inserting member 1430 having, e.g., a knife or wedge shape is inserted into the cavity-containing layer 2 of the sample 1100, thereby completely separating the sample 1100.

The holding portions 1410 and 1420 have chuck mechanisms (e.g., vacuum chuck mechanisms or electrostatic chuck mechanisms) 1411 and 1421 for chucking the sample 1100, respectively.

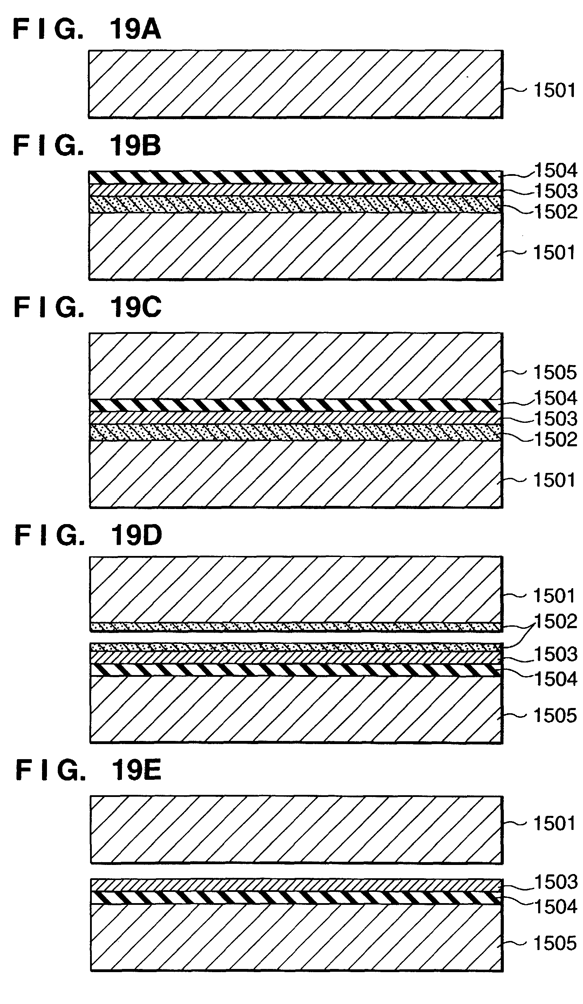

A method of manufacturing a SOI substrate or the like using the above separating apparatus will be described next. Figs. 19A to 19E are sectional views for explaining steps in manufacturing an SOI substrate according to a preferred embodiment of the present invention.

In the step shown in Fig. 19A, a single-crystal Si substrate is prepared as a first substrate 1501. In the step shown in Fig. 19B, the first substrate 1501 is processed to form a substrate having a cavity-containing layer 1502 and a non-cavity-containing layer 1503 on the cavity-containing layer 1502.

To form the cavity-containing layer 1502 and non-cavity-containing layer 1503, the following methods can be used.

(1) The first substrate 1501 is anodized to form a cavity-containing layer (porous layer) 1502, and a non-cavity-containing layer 1503 is formed on the cavity-containing layer 1502.

(2) Ions of at least one element selected from a rare gas, hydrogen, and nitrogen are implanted into the first substrate 1501 to form an ion-implanted layer or a cavity-containing layer (microcavity layer) 1502, and a layer on the cavity-containing layer 1502 is used as a non-cavity-containing layer 1503.

(3) The first substrate 1501 is anodized to form a cavity-containing layer (porous layer). In addition, ions of at least one element selected from a rare gas, hydrogen, and nitrogen into the first substrate 1501 to form another cavity-containing layer (microcavity layer), thereby forming a cavity-containing layer 1502 having a multilayered structure. A non-cavity-containing layer 1503 is formed on the cavity-containing layer 1502.

As the non-cavity-containing layer 1503, for example, 1) a single-crystal Si layer, 2) a polysilicon layer, 3) an amorphous Si layer, 4) a metal film, 5) a compound semiconductor film, 6) a superconducting thin film, or 7) a layer containing a semiconductor element (e.g., a transistor, a light-emitting element, or a solar cell) is preferably used.

In the step shown in Fig. 19B, an insulating layer (e.g., $SiO_2$ layer) 1504 is preferably formed on the non-cavity-containing layer 1503. With this insulating layer 1504, the active layer can be separated from the bonding interface.

In method (1), i.e., the method of forming a cavity-containing layer by anodizing, the size or density of cavities in the cavity-containing layer 1502, or the porosity of the cavity-containing layer 1502 can be changed by changing conditions including the density and concentration of the impurity in the first substrate 1501. When processing is performed a plurality of number of times while changing the anodizing conditions, a cavity-containing layer 1502 having a multilayered structure wherein the respective layers have different porosities can be obtained.

When the cavity-containing layer 1502 formed by method (2), i.e., ion implantation is observed with, e. g., a transmission electron microscope, the layer has a number of microcavities. The charged state of ions to be implanted is not particularly limited. The acceleration energy is set such that the projection range matches the depth to which ions are to be implanted. When the ion implantation dose is changed, the size or density of cavities to be formed can be changed. The implantation dose is preferably about $1 \times 10^{15}/cm^2$ or more, and more preferably, $1 \times 10^{16}$ to $1 \times 10^{17}/cm^2$. To deepen the projection range, channeling ion implantation can be used. After ion implantation, annealing is preferably performed as needed.

In the step shown in Fig. 19C, the first substrate side (1501 to 1503 or 1501 to 1504) shown in Fig. 19B is brought into tight contact with an independently prepared second substrate 1505 at room temperature to form a bonded substrate stack. After that, the bonding strength may be increased by anodic bonding, pressing, heating, or a combination thereof.

As the second substrate 1505, for example, 1) a single-crystal Si substrate, 2) a substrate having an insulating layer (e.g., $SiO_2$ layer) on a single-crystal Si substrate, 3) a transparent substrate (e.g., silica substrate), 4) a sapphire substrate, 5) a substrate formed from an insulating material, or 6) a resin substrate (e.g., a card having an IC to form an IC card) is preferably used.

An insulating thin film may be inserted between the first substrate side (1501 to 1503 or 1501 to 1504) and the first substrate 1501 to form a three-layered structure.

The end portions of the cavity-containing layer 1502 are preferably exposed to the outside by, after the process of bonding the two substrates (Fig. 19C), etching (e.g., dry-etching or wet-etching) the non-cavity-containing layer 1503. Alternatively, in the process of forming a non-cavity-containing layer 1503 (Fig. 19B), a non-cavity-containing layer 1503 is formed not to cover the end portions of the first substrate 1501, or in the process of forming a cavity-containing layer 1502 (Fig. 19B), a cavity-containing layer 1502 reaching the end portions of the first substrate 1501 is formed.

In the step shown in Fig. 19D, the bonded substrate stack shown in Fig. 19C is set in the separating apparatus 1200 shown in Fig. 16 and separated by filling the enclosed space 1210 with a high-pressure fluid (first separation processing). As the fluid, either an inert gas such as Ar gas or $N_2$ gas, or a gas such as air, or a liquid such as water (e.g., pure water) can be used.

If the bonded substrate stack is not completely separated by the first separation processing, the second separation processing is executed, as described above.

In the step shown in Fig. 19E, the cavity-containing layer 1502 remaining on the surface on the second substrate side (1503 to 1505 or 1503 and 1505) is selectively removed. When the non-cavity-containing layer 1503 is formed from a single-crystal Si layer, at least one etchant selected from a normal etchant for etching Si, hydrofluoric acid as an etchant for selectively etching porous Si, a mixed solution prepared by adding at least one of an alcohol and hydrogen peroxide to hydrofluoric acid, buffered hydrofluoric acid, and a mixed solution prepared by adding at least one of an alcohol and hydrogen peroxide to buffered hydrofluoric acid is used to remove only the cavity-containing layer 1502 by electroless wet chemical etching. With this process, the non-cavity-containing layer 1503 (or 1503 and 1504) formed on the cavity-containing layer 1502 on the first substrate 1501 is left on the second substrate 1505.

The cavity-containing layer 1502 has a large surface area. For this reason, when the cavity-containing layer 1502 is formed from a single-crystal Si layer, and the underlying non-cavity-containing layer 1503 is also formed from a single-crystal Si layer, only the cavity-containing layer 1502 can be selectively etched using a normal etchant for etching Si. Instead, the cavity-containing layer 1502 may be selectively polished, or only the cavity-containing layer may be accurately polished by controlling the etching time.

When the cavity-containing layer 1502 is formed from a single-crystal Si layer, and the underlying non-cavity-containing layer 1503 is formed from a compound semiconductor layer, the cavity-containing layer 1502 can be selectively etched using an etchant that etches single-crystal Si at a higher rate than the compound semiconductor. Instead, only the cavity-containing layer 1502 may be selectively polished using the compound semiconductor layer as a polishing stopper, or only the cavity-containing layer 1502 may be accurately polished by controlling the etching time.

If the cavity-containing layer 1502 is thin, for example, atoms of the substrate surface migrate upon annealing the bonded substrate stack in an atmosphere containing hydrogen, thereby burying the cavities in the substrate surface. As a consequence, the cavity-containing layer 1502 can be removed.

Normally, after the cavity-containing layer is removed by etching, the substrate surface exposed by removing the cavity-containing layer is rough. Hence, for example, annealing in an atmosphere containing hydrogen or surface planarization such as polishing is preferably performed.

According to this SOI substrate manufacturing method, a large-area substrate having a flat non-cavity-containing layer (e.g., a single-crystal Si layer) having a uniform thickness on the upper side can be formed. A substrate having a non-cavity-containing layer 1503 formed from a single-crystal Si layer, and an insulating layer (e.g., $SiO_2$ layer) 1504 beneath the non-cavity-containing layer 1503 is known as an SOI substrate. The insulating layer 1504 need not always be formed on the non-cavity-containing layer 1503 on the first substrate 1501. Instead, the insulating layer 1504 may be formed on the second substrate 1505 or on both of the non-cavity-containing layer 1503 and second substrate 1505. Consequently, the structure shown in Fig. 19C is obtained. Finally, a substrate having an insulating layer 1504 under a non-cavity-containing layer 1503 can be formed.

In the step shown in Fig. 19E, the cavity-containing layer 1502 remaining on the first substrate 1501 is removed, and surface planarization is done as needed. The substrate can be reused as the first substrate 1501 or second substrate 1505, or a substrate for another application purpose. As surface planarization, annealing in an atmosphere containing hydrogen or polishing is preferable.

Application examples of the separating apparatus 1200 will be described below.

[Application Example 1]

A single-crystal Si substrate was prepared and anodized in an HF solution. A cavity-containing layer (porous layer) was formed on the surface of the substrate. The anodizing conditions were as follows.

Current density: 7 ($mA \cdot cm^{-2}$)
Anodizing solution: HF : $H_2O$ : $C_2H_5OH$ = 1 : 1 : 1
Time: 11 (min)
Thickness of porous Si layer: 12 ($\mu m$)

A 10-$\mu m$ thick single-crystal Si layer was epitaxially grown on the porous Si layer by CVD (Chemical Vapor Deposition). The growth conditions were as follows. At the early stage of epitaxial growth, the surface of the porous Si layer is exposed to the $H_2$ atmosphere. For this reason, cavities near the surface are buried, and the surface becomes flat.

Source gas: $SiH_2Cl_2/H_2$
Gas flow rate: 0.5/180 (l/min)
Gas pressure: 760 (Torr)
Temperature: 1,000 ($^\circ$C)
Growth rate: 1 ($\mu m$/min)

This substrate was set in the separating apparatus 1200, and Ar gas at a high pressure of 900 kg/$cm^2$ was injected (separation processing). After one hour, the pressure was reduced, and the substrate was extracted from the separating apparatus 1200. With the above process, the substrate was separated at the porous Si layer, and a separated epitaxial layer having a thickness of 10 $\mu m$ could be obtained.

Before separation processing, when a member partially having holes is jointed or bonded to the surface side of the epitaxial layer, a membrane (thin film) or a cantilever structure to be used for a micromachine can be formed. With this structure, for example, an acceleration sensor or a surface detection sensor can be formed.

Separation processing may be performed after a semiconductor circuit or a solar cell is formed on the epitaxial layer in advance.

[Application Example 2]

A 0.3-$\mu m$ thick single-crystal Si layer was epitaxially grown on a single-crystal Si substrate by CVD (Chemical Vapor Deposition). The growth conditions were as follows.

Source gas: $SiH_2Cl_2/H_2$

Gas flow rate: 0.5/180 (l/min)
Gas pressure: 80 (Torr)
Temperature: 950 (°C)
Growth rate: 0.3 (μm/min)

A 200-nm thick $SiO_2$ layer was formed on the surface of the epitaxial layer by thermal oxidation. H ions were implanted through the $SiO_2$ layer on the surface at an acceleration energy of 40 keV and a dose of 5 x 16 $cm^{-2}$ to form a cavity-containing layer (microcavity layer).

This substrate was set in the separating apparatus 1200, and water at a high pressure of 1,000 kg/$cm^2$ was injected (separation processing). After one hour, the pressure was reduced, and the substrate was extracted from the separating apparatus 1200. With the above process, the substrate was separated at the microcavity layer, and a separated epitaxial layer having a thickness of 0.2 μm could be obtained.

Before separation processing, when a member partially having holes is jointed or bonded to the surface side of the epitaxial layer, a membrane (thin film) or a cantilever structure to be used for a micromachine can be formed. With this structure, for example, an acceleration sensor or a surface detection sensor can be formed.

Separation processing may be performed after a semiconductor circuit or a solar cell is formed on the epitaxial layer in advance.

[Application Example 3]

A single-crystal Si substrate was prepared and anodized in an HF solution. A cavity-containing layer (porous layer) having a multilayered structure formed from a plurality of layers with different porosities was formed on the surface of the substrate. The anodizing conditions were as follows.

<First Anodizing Conditions>

Current density: 7 ($mA·cm^{-2}$ )
Anodizing solution: HF : $H_2O$ : $C_2H_5OH$ = 1 : 1 : 1
Time: 11 (min)
Thickness of porous Si layer: 12 (μm)

<Second Anodizing Conditions>

Current density: 21 ($mA·cm^{-2}$)
Anodizing solution: HF : $H_2O$ : $C_2H_5OH$ = 1 : 1 : 1
Time: 2 (min)
Thickness of porous Si layer: 3 (μm)

The porous layer formed under the second anodizing conditions has a higher porosity than that of the porous layer formed under the first anodizing conditions.

This substrate was set in the separating apparatus 1200, and water at a high pressure of 700 kg/$cm^2$ was injected (separation processing). After 30 minutes, the pressure was reduced, and the substrate was extracted from the separating apparatus 1200. With the above process, the substrate was separated near the interface between the first and second porous layers.

Before separation processing, when a member partially having holes is jointed or bonded to the surface side of the epitaxial layer, a membrane (thin film) or a cantilever structure to be used for a micromachine can be formed. With this structure, for example, an acceleration sensor or a surface detection sensor can be formed.

Separation processing may be performed after a semiconductor circuit or a solar cell is formed on the epitaxial layer in advance.

[Application Example 4]

A single-crystal Si substrate was prepared and anodized in an HF solution. A cavity-containing layer (porous layer) having a multilayered structure formed from a plurality of layers with different porosities was formed on the surface of the substrate. The anodizing conditions were as follows.

<First Anodizing Conditions>

Current density: 7 ($mA·cm^{-2}$)
Anodizing solution: HF : $H_2O$ : $C_2H_5OH$ = 1 : 1 : 1
Time: 11 (min)
Thickness of porous Si layer: 12 (μm)

<Second Anodizing Conditions>

Current density: 10 ($mA·cm^{-2}$)
Anodizing solution: HF : $H_2O$ : $C_2H_5OH$ = 1 : 2 : 2
Time: 3 (min)
Thickness of porous Si layer: 3 (μm)

<Third Anodizing Conditions>

Current density: 7 ($mA·cm^{-2}$)
Anodizing solution: HF : $H_2O$ : $C_2H_5OH$ = 1 : 1 : 1
Time: 1 (min)
Thickness of porous Si layer: 1.1 (μm)

The porous layer formed under the second anodizing conditions has a higher porosity than that of the porous layer formed under the first anodizing conditions.

This substrate was set in the separating apparatus 1200, and Ar gas at a high pressure of 700 kg/$cm^2$ was injected (separation processing). After 30 minutes, the pressure was reduced, and the substrate was extracted from the separating apparatus 1200. With the above process, the substrate was separated near the interface between the first and second porous layers, near the interface between the second and third porous layers, or in the second porous layer.

Before separation processing, when a member partially having holes is jointed or bonded to the surface side of the epitaxial layer, a membrane (thin film) or a cantilever structure to be used for a micromachine can be formed. With this structure, for example, an acceleration sensor or a surface detection sensor can be formed.

Separation processing may be performed after a semiconductor circuit or a solar cell is formed on the epitaxial layer in advance.

[Application Example 5]

A single-crystal Si substrate (first substrate) was prepared and anodized under the anodizing conditions described in application example 1, 3, or 4 to form a cavity-containing layer (porous Si layer) on the substrate surface. The substrate surface was oxidized in an oxygen atmosphere at 400°C for 1 hr, thereby forming a thermal oxide film on the inner walls of cavities in the porous Si layer.

A 0.3-μm thick single-crystal Si layer was epitaxially grown on the porous Si layer by CVD (Chemical Vapor Deposition). The growth conditions were as follows. At the early stage of epitaxial growth, the surface of the porous Si layer is exposed to the $H_2$ atmosphere. For this reason, cavities near the surface are buried, and the surface becomes flat.

Source gas: $SiH_2Cl_2/H_2$
Gas flow rate: 0.5/180 (l/min)
Gas pressure: 80 (Torr)
Temperature: 950 (°C)
Growth rate: 0.3 (μm/min)

A 200-nm thick $SiO_2$ layer was formed on the surface of the epitaxial layer by thermal oxidation. The surface of this $SiO_2$ layer and the surface of an independently prepared Si substrate (second substrate) were overlaid on and brought into contact with each other. The resultant structure was annealed at 1,000°C for 1 hr to form a bonded substrate stack.

This bonded substrate stack was set in the separating apparatus 1200, and pure water at a high pressure of 900 kg/cm$^2$ was injected (separation processing). After 30 minutes, the pressure was reduced, and the substrate was extracted from the separating apparatus 1200. With the above process, the bonded substrate stack was separated into two substrates at the porous layer. A porous Si layer formed using a high current density breaks even under a relatively low-pressure environment. Even under a high-pressure environment, no problem is posed unless portions other than the porous layer break. When a number of bonded substrate stacks having different porous structures are to be batch-processed, a pressure capable of separating a bonded substrate stack with the highest porous-layer intensity is selected.

The porous Si layer remaining on the second substrate side was selectively etched using a mixed solution of 49% hydrofluoric acid, 30% hydrogen peroxide, and water. The single-crystal Si layer functioned as an etching stopper. Only the porous Si layer was selectively etched and completely removed.

The etching rate of non-porous single-crystal Si by the etchant is very low, and the selectivity ratio between the porous Si layer and the non-porous Si layer reaches 10$^5$ or more. A decrease in film thickness (about several ten angstrom) due to etching of the non-porous layer can be neglected in practical use.

With the above process, a single-crystal Si layer having a thickness of 0.2 μm could be formed on the Si oxide film. The film thickness of the single-crystal Si layer at that time was measured at 100 points on the entire surface. The film thickness uniformity was 201 nm ± 4 nm.

The resultant structure was annealed in a hydrogen atmosphere at 1,100°C for 1 hr. The surface roughness of the single-crystal Si layer at that time was evaluated with an atomic force microscope. The root mean square roughness in a 50-μm square area was approximately 0.2 nm. This nearly equals that of a commercially available Si wafer.

The section of the substrate formed following the above method was observed with a transmission electron microscope. No new crystal defects were found in the single-crystal Si layer; satisfactory crystallinity was maintained.

The same result as described above can be obtained even when no oxide film is formed on the surface of the epitaxial Si layer.

The porous Si layer remaining on the first substrate side may be selectively etched using a mixed solution of 49% hydrofluoric acid, 30% hydrogen peroxide, and water. At this time, the single-crystal Si layer functions as an etching stopper. Only the porous Si layer is selectively etched and completely removed. This substrate can be used as the first substrate in the anodizing process or as the second substrate in the bonding process.

After the porous Si layer remaining on the first substrate side is selectively etched, the substrate may be annealed in hydrogen at 1,100°C for 1 hr to recover (planarize) the surface roughness (microroughness) due to microholes before reuse. However, when the substrate is to be reused as the first substrate, the above microroughness planarization is not always necessary. This is because the surface is planarized simultaneously with sealing holes on the surface of the porous Si layer during prebaking in hydrogen at the early stage of epitaxial growth.

Instead of annealing in hydrogen, the microroughness due to microholes may be planarized by surface touch polishing.

[Application Example 6]

Application Example 5 was changed as follows.

1) The thickness of the epitaxial Si layer: 2μm
2) The thermal oxide film on the surface of the epitaxial Si layer: 0.1μm
3) The second substrate: an Si substrate having a 1.9-μm thick $SiO_2$ layer
4) Bonding: After the surfaces of two substrates were exposed to a nitrogen plasma, the two substrate were rinsed in water, superposed, brought into contact with each other, and annealed at 400°C for 10 hrs.

[Application Example 7]

Application Example 5 were changed as follows.

1) The second substrate: a silica substrate
2) Bonding: After the surfaces of two substrates were exposed to a nitrogen plasma, the two substrate were rinsed in water, superposed, brought into contact with each other, and annealed at 200°C for 24 hrs.
3) Annealing in hydrogen: the structure was further annealed in hydrogen at 970°C for 2 hrs (When the surface roughness was evaluated with an atomic force microscope, the mean square roughness in a 50-μm square area was approximately 0.2 nm. This nearly equals that of a commercially available Si wafer).
4) The separated substrate is reused as the first substrate.

[Application Example 8]

A single-crystal Si substrate was prepared and anodized in an HF solution. A cavity-containing layer (porous layer) having a multilayered structure formed from a plurality of layers with different porosities was formed on the surface of the substrate. The anodizing conditions were as follows.

<First Anodizing Conditions>

Current density: 7 ($mA \cdot cm^{-2}$)
Anodizing solution: HF : $H_2O$ : $C_2H_5OH$ = 1 : 1 : 1
Time: 5 (min)
Thickness of porous Si layer: 6 (μm)

<Second Anodizing Conditions>

Current density: 30 ($mA \cdot cm^{-2}$)
Anodizing solution: HF : $H_2O$ : $C_2H_5OH$ = 1 : 1 : 1
Time: 110 (sec)
Thickness of porous Si layer: 3 (μm)

This substrate was oxidized in an oxygen atmosphere at 400°C for 1 hr. Upon this oxidation, the inner walls of cavities in the porous Si layer were covered with thermal oxide films. A 1-μm thick single-crystal

GaAs layer was epitaxially grown on the porous Si layer by CVD (Chemical Vapor Deposition). The growth conditions were as follows.
Source gas: TMG/$AsH_3$/$H_2$
Gas pressure: 80 (Torr)
Temperature: 700 (°C)

The surface of the GaAs layer and the surface of an independently prepared Si substrate (second substrate) were overlaid on and brought into contact with each other to form a bonded substrate stack. This bonded substrate stack was set in the separating apparatus 1200, and pure water at a high pressure of 900 kg/$cm^2$ was injected. After 30 minutes, the pressure was reduced, and the substrate was extracted from the separating apparatus 1200. With the above process, the bonded substrate stack was separated into two substrates at the porous layer and, more specifically, near the interface between the first and second porous Si layers.

The porous Si layer remaining on the second substrate side was etched using a mixed solution of ethylenediamine, pyrocatechol and water (ratio is 17 ml : 3 g : 8 ml) at 110°C. The single-crystal GaAs layer functioned as an etching stopper. Only the porous Si layer was selectively etched and completely removed.

The etching rate of non-porous single-crystal GaAs by the etchant is very low. A decrease in film thickness (about several ten angstrom) due to etching of the non-porous layer can be neglected in practical use.

With the above process, a single-crystal GaAs layer having a thickness of 1 μm could be formed on the single-crystal Si layer. The film thickness of the single-crystal GaAs layer at that time was measured at 100 points on the entire surface. The film thickness uniformity was 1 μm ± 29.8 nm.

Section observation with a transmission electron microscope revealed no new crystal defects in the GaAs layer, indicating that satisfactory crystallinity was maintained.

When an Si substrate having an oxide film is used as the support substrate (second substrate), a substrate having a GaAs layer on the insulating film can be formed.

The porous Si layer remaining on the first substrate side may be selectively etched using a mixed solution of 49% hydrofluoric acid and 30% hydrogen peroxide while stirring the solution. At this time, the single-crystal Si layer functions as an etching stopper. Only the porous Si layer is selectively etched and completely removed. This substrate can be used as the first substrate in the anodizing process or as the second substrate in the bonding process.

After the porous Si layer remaining on the first substrate side is selectively etched, the substrate may be annealed in hydrogen at 1,100°C for 1 hr to recover (planarize) the surface roughness (microroughness) due to microholes before reuse. However, when the substrate is to be reused as the first substrate, the above microroughness planarization is not always necessary. This is because the surface is planarized simultaneously with sealing holes on the surface of the porous Si layer during prebaking in hydrogen at the early stage of epitaxial growth.

Instead of annealing in hydrogen, the microroughness due to microholes may be planarized by surface touch polishing.

[Application Example 9]

A single-crystal Si substrate was prepared as the first substrate and anodized in an HF solution. A cavity-containing layer (porous layer) having a multilayered structure formed from a plurality of layers with different porosities was formed on the surface of the substrate. The anodizing conditions were as follows.

<First Anodizing Conditions>

Current density: 7 (mA·cm$^{-2}$)
Anodizing solution: HF : $H_2O$ : $C_2H_5OH$ = 1 : 1 : 1
Time: 11 (min)
Thickness of porous Si layer: 12 ($\mu$m)
Porosity: ~ 24%

<Second Anodizing Conditions>

Current density: 10 (mA·cm$^{-2}$)
Anodizing solution: HF : $H_2O$ : $C_2H_5OH$ = 1 : 2 : 2
Time: 3 (min)
Thickness of porous Si layer: 3 ($\mu$m)
Porosity: ~ 35%

The porous layer formed under the second anodizing conditions has a higher porosity than that of the porous layer formed under the first anodizing conditions.

This substrate was oxidized in an oxygen atmosphere at 400°C for 1 hr. Upon this oxidation, the inner walls of cavities in the porous Si layer were covered with thermal oxide films. A 1-$\mu$m thick single-crystal InP layer was epitaxially grown on the porous Si layer by MOCVD (Metal Organic Chemical Vapor Deposition).

The surface of the InP layer and the surface of an independently prepared silica substrate (second substrate) were exposed to a nitrogen plasma. After this, the substrates were overlaid on and brought into contact with each other, and were annealed at 200°C for 10 hrs to form a bonded substrate stack.

This bonded substrate stack was set in the separating apparatus 1200, and pure water at a high pressure of 900 kg/cm$^2$ was injected. After 30 minutes, the pressure was reduced, and the substrate was extracted from the separating apparatus 1200. With the above process, the bonded substrate stack was separated into two substrates at the porous layer and, more specifically, near the interface between the first and second porous Si layers.

The porous Si layer remaining on the second substrate side was selectively etched using a mixed solution of 49% hydrofluoric acid and 30% hydrogen peroxide while stirring the solution. At this time, the single-crystal InP layer functioned as an etching stopper. Only the porous Si layer was selectively etched and completely removed.

The etching rate of non-porous single-crystal InP by the etchant is very low. A decrease in film thickness (about several ten angstrom) due to etching of the non-porous layer can be neglected in practical use.

With the above process, a single-crystal InP layer having a thickness of 1 $\mu$m could be formed on the silica substrate. The film thickness of the single-crystal InP layer at that time was measured at 100 points on the entire surface. The film thickness uniformity was 1 $\mu$m ± 29.0 nm.

Section observation with a transmission electron microscope revealed no new crystal defects in the InP layer, demonstrating that satisfactory crystallinity was maintained.

The porous Si layer remaining on the first substrate side may be selectively etched using a mixed solution of 49% hydrofluoric acid and 30% hydrogen peroxide while stirring the solution. At this time, the single-crystal Si layer functions as an etching stopper. Only the porous Si layer is selectively etched and completely removed. This substrate can be used as the first substrate in the anodizing process.

After the porous Si layer remaining on the first substrate side is selectively etched, the substrate may be annealed in hydrogen at 1,100°C for 1 hr to recover (planarize) the surface roughness (microroughness) due to microholes before reuse. However, when the substrate is to be reused as the first substrate, the above microroughness planarization is not always necessary. This is because the surface is planarized simultaneously with sealing holes on the surface of the porous Si layer during prebaking in hydrogen at the early stage of epitaxial growth.

Instead of annealing in hydrogen, the microroughness due to microholes may be planarized by surface touch polishing.

[Application Example 10]

In, e.g., Application Example 1, cavity-containing layers (porous layers) may be formed on both sides of a single-crystal Si substrate. In this case, single-crystal Si layer are epitaxially grown on the cavity-containing layers. After this, this substrate is set in the separating apparatus 1200 and separated into three substrates at the two porous layers.

[Application Example 11]

A single-crystal Si substrate was prepared as the first substrate and anodized in an HF solution. A cavity-containing layer (porous layer) having a multilayered structure formed from a plurality of layers with different porosities was formed on the surface of the substrate. The anodizing conditions were as follows.

<First Anodizing Conditions>

Current density: 1 (mA·cm$^{-2}$)
Anodizing solution: HF : H$_2$O : C$_2$H$_5$OH = 1 : 1 : 2
Time: 8 (min)

<Second Anodizing Conditions>

Current density: 7 (mA·cm$^{-2}$)
Anodizing solution: HF : H$_2$O : C$_2$H$_5$OH = 1 : 1 : 2
Time: 8 (min)

<Third Anodizing Conditions>

Current density: 100 (mA·cm$^{-2}$)
Anodizing solution: HF : H$_2$O : C$_2$H$_5$OH = 1 : 1 : 2
Time: 0.1 (min)

Under the third anodizing conditions, a porous layer is formed by anodizing in the porous layer formed under the second anodizing conditions.

A 0.3-μm thick single-crystal Si layer was epitaxially grown on the porous Si layer by CVD (Chemical Vapor Deposition). The growth conditions were as follows. At the early stage of epitaxial growth, the surface of the porous Si layer is exposed to the H$_2$ atmosphere. For this reason, cavities near the surface are buried, and the surface becomes flat.

Source gas: SiH$_2$Cl$_2$/H$_2$
Gas flow rate: 0.5/180 (l/min)
Gas pressure: 80 (Torr)
Temperature: 950 (°C)
Growth rate: 0.3 (μm/min)

A 200-nm thick SiO$_2$ layer was formed on the surface of the epitaxial layer by thermal oxidation. The surface of the SiO$_2$ layer and the surface of an independently prepared Si substrate (second substrate) were overlaid on and brought into contact with each other, and were annealed at 1,000°C for 1 hr to form a bonded substrate stack.

This bonded substrate stack was set in the separating apparatus 1200, and pure water at a high pressure of 900 kg/cm$^2$ was injected. After 30 minutes, the pressure was reduced, and the substrate was extracted from the separating apparatus 1200. With the above process, the bonded substrate stack was separated into two substrates at the porous layer. A porous Si layer formed using a high current density breaks even under a relatively low-pressure environment. Even under a high-pressure environment, no problem is posed unless portions other than the porous layer break. When a number of bonded substrate stacks having different porous structures are to be batch-processed, a pressure capable of separating a bonded substrate stack with the highest porous-layer intensity is selected.

The porous Si layer remaining on the second substrate side was selectively etched using a mixed solution of 49% hydrofluoric acid, 30% hydrogen peroxide, and water. The single-crystal Si layer functioned as an etching stopper. Only the porous Si layer was selectively etched and completely removed.

The etching rate of non-porous single-crystal Si by the etchant is very low, and the selectivity ratio between the porous Si layer and the non-porous Si layer reaches 10 or more. A decrease in film thickness (about several ten angstrom) due to etching the non-porous layer can be neglected in practical use.

With the above process, a single-crystal Si layer having a thickness of 0.2 μm could be formed on the Si oxide film. The film thickness of the single-crystal Si layer at that time was measured at 100 points on the entire surface. The film thickness uniformity was 201 nm ± 4 nm.

The resultant structure was annealed in a hydrogen atmosphere at 1,100°C for 1 hr. The surface roughness of the single-crystal Si layer at that time was evaluated with an atomic force microscope. The mean square roughness in a 50-μm square area was approximately 0.2 nm. This nearly equals that of a commercially available Si wafer.

The section of the substrate formed following the above method was observed with a transmission electron microscope. No new crystal defects were found in the single-crystal Si layer; satisfactory crystallinity was maintained.

The same result as described above can be obtained even when no oxide film is formed on the surface of the epitaxial Si layer.

The porous Si layer remaining on the first substrate side may be selectively etched using a mixed solution of 49% hydrofluoric acid, 30% hydrogen peroxide, and water. At this time, the single-crystal Si layer functions as an etching stopper. Only the porous Si layer is selectively etched and completely removed. This substrate can be used as the first substrate in the anodizing process or as the second substrate in the bonding process.

After the porous Si layer remaining on the first substrate side is selectively etched, the substrate may be annealed in hydrogen at 1,100°C for 1 hr to recover (planarize) the surface roughness (microroughness) due to microholes before reuse. However, when the substrate is to be reused as the first substrate, the above microroughness planarization is not always necessary. This is because the surface is planarized simultaneously with sealing holes on the surface of the porous Si layer during prebaking in hydrogen at the early stage of epitaxial growth.

Instead of annealing in hydrogen, the microroughness due to microholes may be planarized by surface touch polishing.

[Application Example 12]

In, e.g., Application Example 5, after forming the epitaxial layer, an element such as a transistor, capacitor, diode, CMOS, IC, or memory can be formed using the epitaxial layer. The methods of forming these elements are well-known, and a detailed description thereof will be omitted.

For example, a passivation insulating film was formed on the surface of the resultant element. This substrate was bonded to the second substrate to form a bonded substrate stack. To bond the substrates, an adhesive may be used, or the above bonding method may be used after the passivation insulating film is planarized by, e.g., CMP (Chemical Mechanical Polishing).

This bonded substrate stack was set in the separating apparatus 1200 and pure water at a high pressure of 900 $kg/cm^2$ was injected (separation processing). After 30 minutes, the pressure was reduced, and the substrate was extracted from the separating apparatus 1200. With the above process, the bonded substrate stack was separated into two substrates at the porous layer.

A porous Si layer formed using a high current density breaks even under a relatively low-pressure environment. Even under a high-pressure environment, no problem is posed unless portions other than the porous layer break. When a number of bonded substrate stacks having different porous structures are to be batch-processed, a pressure capable of separating a bonded substrate stack with the highest porous-layer intensity is selected.

The porous Si layer remaining on the second substrate side was selectively etched using a mixed solution of 49% hydrofluoric acid, 30% hydrogen peroxide, and water. The single-crystal Si layer functioned as an etching stopper. Only the porous Si layer was selectively etched and completely removed.

The etching rate of non-porous single-crystal Si by the etchant is very low, and the selectivity ratio between the porous Si layer and the non-porous Si layer reaches $10^5$ or more. A decrease in film thickness (about several ten angstrom) due to etching of the non-porous layer can be neglected in practical use.

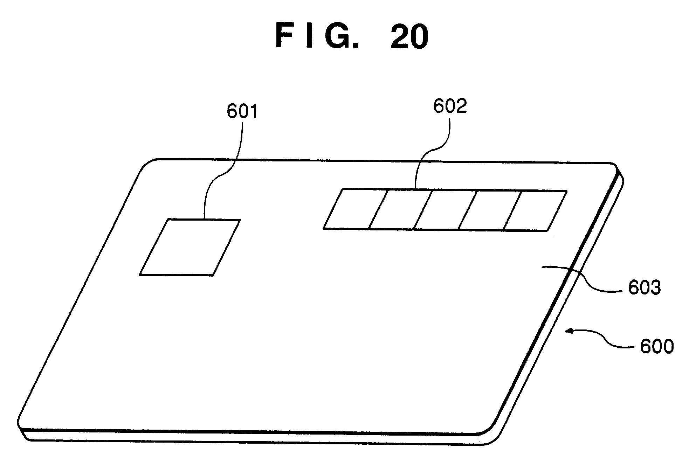

As the second substrate, not only a semiconductor substrate or insulating substrate but also a resin substrate for an IC card can be used. Fig. 20 is a view schematically showing the arrangement of an IC card. Referring to Fig. 20, reference numeral 601 denotes an IC chip; 602, a solar cell; and 603, a resin substrate (card main body).

For example, an IC is formed on the non-cavity-containing layer on the cavity-containing layer of the first substrate, and a passivation film is formed on the IC. This substrate is diced. A diced chip is bonded at a predetermined position on the resin substrate 603 as the second substrate. After this, the chip is separated at the cavity-containing layer by the separating apparatus 1200 to leave the IC chip 601 on the resin substrate 603.

In a similar way, a solar cell is formed on the non-cavity-containing layer on the cavity-containing layer of the first substrate, and a passivation film is formed on the solar cell. This substrate is diced. The diced chip is bonded at a predetermined position on the resin substrate 603 as the second substrate. After this, the chip is separated at the cavity-containing layer by the separating apparatus 1200 to leave the solar cell 602 on the resin substrate 603.

According to Application Example 12, a thin-film semiconductor chip or solar cell chip can be bonded to the resin substrate. Hence, the thickness of, e.g., an IC card 600 can be reduced.

[Application Example 13]

To epitaxially grow a semiconductor layer on a porous Si layer, not only CVD but also e.g., MBE, sputtering, or liquid phase growth may be employed.

The selective etchant for the cavity-containing Si layer such as a porous Si layer is not limited to the mixed solution of hydrofluoric acid and hydrogen peroxide. For example, a mixed solution of hydrofluoric acid and water, a mixed solution prepared by adding at least one of an alcohol and hydrogen peroxide to hydrofluoric acid and water, buffered hydrofluoric acid, a mixed solution prepared by adding at least one of an alcohol and hydrogen peroxide to buffered hydrofluoric acid, or a mixed solution of hydrofluoric acid, nitric acid, and acetic acid may be employed. This is because the cavity-containing Si layer such as a porous Si layer is easy to selectively etch due to its large surface area.

Other processes also are not limited to the above application examples, either, and various changes and modifications can be made.

According to the present invention, an apparatus and method suitable to separate a member such as a bonded substrate stack can be provided.

The present invention is not limited to the above embodiments and various changes and modifications can be made within the spirit and scope of the present invention. Therefore, to apprise the public of the scope of the present invention, the following claims are made.

**Claims**

1. A separating apparatus for separating a sample (101) having a separation layer (101b) at the separation layer (101b), characterized by comprising:
    a pressure application mechanism (201, 202, 220) for applying a pressure of a fluid substantially standing still at least part of the separation layer (101b) to separate the sample (101) at the separation layer (101b).

2. The apparatus according to claim 1, characterized in that the separation layer (101b) extends across in the sample (101) and is exposed to an edge of the sample (101), and said pressure application mechanism (201, 202, 220) applies the pressure of the fluid to the separation layer (101b) from at least part of the edge of the sample (101).

3. The apparatus according to claim 2, characterized in that said pressure application mechanism (201, 202, 220) has an enclosed space forming member (201, 202) for surrounding at least part of a peripheral portion of the sample (101) to form an enclosed space and applies a pressure higher than that of an external space to the enclosed space.

4. The apparatus according to claim 3, characterized in that said enclosed space forming member (201, 202) has a structure which allows the sample (101) to expand near a central portion due to the pressure of the fluid injected into the sample (101) while breaking the separation layer (101b).

5. The apparatus according to claim 4, characterized by further comprising a limiting member (301, 302) for limiting the expansion amount near the central portion of the sample (101).

6. The apparatus according to any one of claims 3 to 5, characterized in that the sample (101) has a disk shape, and said enclosed space forming member (201, 202) forms the enclosed space around the entire peripheral portion of the sample (101).

7. The apparatus according to 6, characterized in that said enclosed space forming member (201, 202) has an annular shape.

8. The apparatus according to any one of claims 3 to 5, characterized in that said enclosed space forming member comprises a pair of support members (201, 202) for sandwiching the peripheral portion of the sample from both sides and supporting the sample, and the enclosed space is formed around the entire peripheral portion of the sample (101) while the sample (101) is supported by said pair of support members (201, 202).

9. The apparatus according to claim 8, characterized in that each of said pair of support members (201, 202) has a sealing member (203, 204) along the edge of the sample.

10. The apparatus according to claim 9, characterized in that the sample (101) has a disk shape, and said sealing member (203, 204) has an annular shape.

11. The apparatus according to claim 9 or 10 characterized in that each of said pair of support members (201, 202) has an annular shape.

12. The apparatus according to claim 2, characterized in that said pressure application mechanism comprises a pair of support members (301, 302) for sandwiching the sample (101) from both sides and supporting the sample, each of said support members having a sealing member (303, 304) located along the edge of the sample to form an enclosed space around a peripheral portion of the sample (101), and said pressure application mechanism applies a pressure higher than that of an external space to the enclosed space.

13. The apparatus according to claim 12, characterized in that each of said pair of support members (301, 302) has a structure (301a, 302a) for connecting a space formed inside said sealing member (303, 304) to the external space while supporting the sample (101).

14. The apparatus according to claim 13, characterized in that each of said pair of support members (301, 302) comprises a plate member for covering both the sides of the sample (101) while supporting the sample (101), said plate member having a through hole.

15. The apparatus according to any one of claims 3 to 14, characterized in that said pressure application mechanism (201, 202) has an injection portion (208) for injecting the fluid into the enclosed space (210).

16. The apparatus according to any one of claims 1 to 15, characterized in that said pressure application mechanism (201, 202) has a pressure adjustment mechanism (220) for adjusting the pressure to be applied to the separation layer (101b).

17. The apparatus according to claim 16, characterized in that said pressure adjustment mechanism (220) gradually or stepwise reduces the pressure to be applied to the separation layer (101b) to separate the sample (101).

18. The apparatus according to any one of claims 1 to 17, characterized in that the fluid is water.

19. The apparatus according to any one of claims 1 to 18, characterized in that the separation layer (101b) is a layer (12) having a fragile structure.

20. The apparatus according to any one of claims 1 to 18, characterized in that the separation layer (101b) is a porous layer (12).

**21.** The apparatus according to any one of claims 1 to 18, characterized in that the separation layer (101b) is a layer (12) having microcavities.

**22.** The apparatus according to claim 21, characterized in that the microcavities are formed by ion implantation.

**23.** The apparatus according to any one of claims 1 to 22, characterized in that the sample (101) has, at the edge, a groove having a substantially V-shaped section.

**24.** A separating method of separating a sample (101) having a separation layer (101b) at the separation layer (101b), characterized by comprising:

the separation step of applying a pressure of a fluid substantially standing still at least part of the separation layer (101b) to separate the sample (101) at the separation layer (101b).

**25.** The method according to claim 24, characterized in that the separation layer (101b) extends across in the sample (101) and is exposed to an edge of the sample, and the separation step comprises applying the pressure of the fluid to the separation layer (101b) from at least part of the edge of the sample (101).

**26.** The method according to claim 25, characterized in that the separation step comprises forming an enclosed space (210) by surrounding at least part of a peripheral portion of the sample (101), filling the enclosed space (210) with the fluid, and applying a pressure higher than that of an external space to the fluid.

**27.** The method according to claim 26, characterized in that the separation step comprises separating the sample (101), while allowing the sample (101) to expand near a central portion due to the pressure of the fluid which is injected into the sample (101) and breaks the separation layer (101b) and limiting the expansion amount.

**28.** The method according to claim 26 or 27, characterized in that the sample (101) has a disk shape, and the separation step comprises forming the enclosed space around the entire peripheral portion of the sample and applying the pressure higher than that of the external space to the enclosed space.

**29.** The method according to any one of claims 24 to 28, characterized in that the separation step comprises separating the sample (101) while changing the pressure to be applied to the separation layer.

**30.** The method according to any one of claims 24 to 28, characterized in that the separation step comprises separating the sample (101) while gradually or stepwise reducing the pressure to be applied to the separation layer (101b).

**31.** The method according to any one of claims 26 to 28, characterized in that the separation step comprises separating the sample while changing the pressure to be applied to the fluid in the enclosed space (210).

**32.** The method according to any one of claims 26 to 28, characterized in that the separation step comprises separating the sample (101) while gradually or stepwise reducing the pressure to be applied to the fluid in the enclosed space (210).

**33.** The method according to any one of claims 24 to 32, characterized in that the fluid is water.

**34.** The method according to any one of claims 24 to 33, characterized in that the separation layer (101b) is a layer (12) having a fragile structure.

**35.** The method according to any one of claims 24 to 33, characterized in that the separation layer (101b) is a porous layer (12).

**36.** The method according to any one of claims 24 to 33, characterized in that the separation layer (101b) is a layer (12) having microcavities.

**37.** The method according to claim 36, characterized in that the microcavities are formed by ion implantation.

**38.** The method according to any one of claims 24 to 37, characterized in that the sample (101) has, at the edge, a groove having a substantially V-shaped section.

**39.** A semiconductor substrate separated by the separating method of any one of claims 24 to 38.

**40.** A method of manufacturing a semiconductor substrate, characterized by comprising:

the first step of forming a first substrate (10) having a separation layer (12) and, on the separation layer, a semiconductor layer (13) to be transferred to onto a second substrate (20) later;
the second step of bonding the first substrate (10) to the second substrate (20) via the semiconductor layer (13) to form a bonded substrate stack; and
the third step of separating the bonded substrate stack at the separation layer (12) by the separating method of any one of claims 24 to 33 to transfer the semiconductor layer (13) from the first substrate (10) to the second substrate (20).

41. The method according to claim 40, characterized in that the separation layer (12) is a porous layer.

42. The method according to claim 41, characterized in that the porous layer (12) comprises a plurality of layers having different porosities.

43. The method according to claim 41 or 42, characterized in that the first step comprises using an Si substrate as a material of the first substrate (10) and anodizing the Si substrate to form the porous layer (12).

44. The method according to claim 43, characterized in that the first step comprises forming, as the semiconductor layer (13), a single-crystal Si layer on the porous layer (12) by epitaxial growth.

45. The method according to claim 44, characterized in that the first step comprises further forming an insulating layer (15) on the single-crystal Si layer (13).

46. The method according to claim 45, characterized in that the insulating layer (15) is formed by oxidizing a surface of the single-crystal Si layer (13).

47. The method according to any one of claims 40 to 46, characterized in that the second substrate (20) is an Si substrate.

48. The method according to any one of claims 40 to 46, characterized in that the second substrate (20) is a transparent substrate.

49. The method according to claim 40, characterized in that the separation layer (12) is a layer having microcavities.

50. The method according to claim 49, characterized in that the microcavities are formed by ion implantation.

51. A separating method of separating a sample (1100) having a cavity-containing layer (2) with a number of cavities at the cavity-containing layer (2), characterized by comprising:

    the storing step of storing the sample (1100) in a closed vessel (1201); and
    the separation step of setting an internal space of said closed vessel (1201) at a high pressure to break cavity walls in the cavity-containing layer (2) and separate at least part of the sample (1100) at the cavity-containing layer (2).

52. The method according to claim 51, characterized in that the separation step comprises applying a pressure into said closed vessel (1201) such that the cavity walls break due to a pressure difference between a pressure in the cavity and that in said closed vessel (1201).

53. The method according to claim 51, characterized by further comprising the final separation step of breaking the cavity-containing layer remaining after the separation step as an unseparated region to completely separate the sample (1100).

54. The method according to claim 53, characterized in that the final separation step comprises applying a vibration energy (1250) to the sample (1100) to break the cavity-containing layer (2) remaining after the separation step as the unseparated region.

55. The method according to claim 53 or 54, characterized in that the final separation step is executed while the sample (1100) is being stored in said closed vessel (1201).

56. The method according to claim 53, characterized in that the final separation step comprises applying a press force (1310, 1320) to the sample (1100) to break the cavity-containing layer (2) remaining after the separation step as the unseparated region.

57. The method according to claim 53, characterized in that the final separation step comprises applying a tensile force (1310, 1320) to the sample (1100) to break the cavity-containing layer (2) remaining after the separation step as the unseparated region.

58. The method according to claim 53, characterized in that the final separation step comprises applying a force (1430) to the sample (1100) in a direction parallel to the cavity-containing layer (2) to break the cavity-containing layer (2) remaining after the separation step as the unseparated region.

59. The method according to claim 53, characterized in that the final separation step comprises inserting a member into the cavity-containing layer (2) to break the cavity-containing layer (2) remaining after the separation step as the unseparated region.

60. The method according to claim 53, characterized in that the final separation step comprises soaking the cavity-containing layer (2) with a liquid and heating the liquid.

61. The method according to claim 53, characterized in that the final separation step comprises soaking the cavity-containing layer (2) with a liquid and cooling the liquid.

62. The method according to claim 53, characterized in that the final separation step comprises soaking the cavity-containing layer (2) with a substance of liquid condition and expanding the volume of the substance.

63. The method according to claim 53, characterized in that the final separation step comprises ejecting a stream of a fluid toward a gap in the sample (1100), which is formed in the separation step, to break the cavity-containing layer (2) remaining after the separation step as the unseparated region.

64. The method according to any one of claims 51 to 63, characterized in that the cavity-containing layer (2) is a porous layer.

65. The method according to any one of claims 51 to 63, characterized in that the cavity-containing layer (2) is a porous layer formed by anodizing.

66. The method according to any one of claims 51 to 63, characterized in that the cavity-containing layer (2) is a microcavity layer having bubble-like microcavities.

67. The method according to any one of claims 51 to 63, characterized in that the cavity-containing layer (2) is a microcavity layer having bubble-like microcavities formed by ion implantation.

68. The method according to any one of claims 51 to 67, characterized in that the sample (1100) is formed by bonding a first plate member (10) having the cavity-containing layer to a second plate member (20).

69. A separating apparatus for separating a sample (1100) having a cavity-containing layer (2) with a number of cavities at the cavity-containing layer (2), characterized by comprising:

a vessel (1201) for storing the sample (1100); and
an injection portion (1207) for injecting a high-pressure fluid into said vessel (1201) to break cavity walls in the cavity-containing layer with the pressure of the fluid and separate at least part of the sample (1100) at the cavity-containing layer (2).

70. The apparatus according to claim 69, characterized by further comprising a vibration source (1250) for supplying a vibration energy into said vessel (1201).

71. A method of manufacturing a substrate, characterized by comprising:

the step of forming a first substrate (1501 - 1504) having a cavity-containing layer (1502) with a number of cavities and, on the cavity-containing layer, a non-cavity-containing layer (1503);
the bonding step of bonding the first substrate (1501 - 1504) and an independently prepared second substrate (1505) via the non-cavity-containing layer (1503) to form a bonded substrate stack;
the separation step of storing the bonded substrate stack in a closed vessel (1201) and setting an internal space of said closed vessel (1201) at a high pressure to break cavity walls in the cavity-containing layer (1502) and separate at least part of the bonded substrate stack at the cavity-containing layer (1502).

72. The method according to claim 71, characterized in that the separation step comprises applying a pressure into said closed vessel (1201) such that the cavity walls break due to a pressure difference between a pressure in the cavity and that in said closed vessel (1201).

73. The method according to claim 71, characterized by further comprising the final separation step of breaking the cavity-containing layer (1502) remaining after the separation step as an unseparated region to completely separate the bonded substrate stack.

74. The method according to claim 73, characterized in that the final separation step comprises applying a vibration energy to the bonded substrate stack to break the cavity-containing layer (1502) remaining after the separation step as the unseparated region.

75. The method according to claim 73 or 74, characterized in that the final separation step is executed while the bonded substrate stack is being stored in said closed vessel (1201).

76. The method according to claim 73, characterized in that the final separation step comprises applying a press force to the bonded substrate stack to break the cavity-containing layer (1502) remaining after the separation step as the unseparated region.

77. The method according to claim 73, characterized in that the final separation step comprises applying a tensile force to the bonded substrate stack to break the cavity-containing layer (1502) remaining after the separation step as the unseparated region.

**78.** The method according to claim 73, characterized in that the final separation step comprises applying a force to the bonded substrate stack in a direction parallel to the cavity-containing layer (1502) to break the cavity-containing layer (1502) remaining after the separation step as the unseparated region.

**79.** The method according to claim 73, characterized in that the final separation step comprises soaking the cavity-containing layer (1502) with a liquid and heating or cooling the liquid.

**80.** The method according to claim 73, characterized in that the final separation step comprises ejecting a stream of a fluid toward a gap in the bonded substrate stack, which is formed in the separation step, to break the cavity-containing layer (1502) remaining after the separation step as the unseparated region.

**81.** The method according to any one of claims 71 to 80, characterized in that the cavity-containing layer (1502) is a porous layer.

**82.** The method according to any one of claims 71 to 80, characterized in that the cavity-containing layer (1502) is a porous layer formed by anodizing.

**83.** The method according to any one of claims 71 to 80, characterized in that the cavity-containing layer (1502) is a microcavity layer having bubble-like microcavities.

**84.** The method according to any one of claims 71 to 80, characterized in that the cavity-containing layer (1502) is a microcavity layer having bubble-like microcavities formed by ion implantation.

**85.** The method according to any one of claims 71 to 80, characterized in that the non-cavity-containing layer (1503) includes an Si layer.

**86.** The method according to any one of claims 71 to 80, characterized in that the non-cavity-containing layer (1503, 1504) is an Si layer having an insulating layer on a surface.

**87.** The method according to claim 86, characterized in that the insulating layer (1504) is an Si oxide layer.

**88.** The method according to any one of claims 85 to 87, characterized in that the Si layer (1503) is a single-crystal Si layer.

**89.** The method according to any one of claims 71 to 80, characterized in that the non-cavity-containing layer (1503) is a compound semiconductor layer.

**90.** The method according to any one of claims 71 to 80, characterized in that the non-cavity-containing layer (1503, 1504) is a compound semiconductor layer having an insulating layer on a surface.

**91.** The method according to any one of claims 71 to 80, characterized in that the non-cavity-containing layer (1503) is a layer including a semiconductor element.

**92.** The method according to any one of claims 71 to 91, characterized in that the first substrate is a single-crystal Si substrate.

**93.** The method according to any one of claims 71 to 92, characterized in that the second substrate is a single-crystal Si substrate.

**94.** The method according to any one of claims 71 to 92, characterized in that the second substrate is a single-crystal Si substrate having an Si oxide layer on a surface.

**95.** The method according to any one of claims 71 to 92, characterized in that the second substrate is a transparent substrate.

**96.** The method according to any one of claims 71 to 92, characterized in that the second substrate is a resin substrate.

**97.** The method according to any one of claims 71 to 92, characterized in that the second substrate is a substrate as a main body of an IC card.

**98.** The method according to any one of claims 71 to 97, characterized in that the bonding step comprises one of the anodic bonding step, the pressing step, the heating step, and a combination thereof.

**99.** The method according to any one of claims 71 to 98, characterized by further comprising the removing step of, after the bonded substrate stack is completely separated, removing the cavity-containing layer remaining on the second substrate.

**100.** The method according to claim 99, characterized in that the removing step comprises the etching step.

**101.** The method according to claim 99, characterized in that the removing step comprises the polishing step.

**102.** The method according to any one of claims 71 to 101, characterized by further comprising, after the removing step, the planarization step of planarizing a surface of the non-cavity-containing layer on the second substrate.

**103.** The method according to claim 102, characterized in that the planarization step comprises the polishing step.

**104.** The method according to claim 102, characterized in that the planarization step comprises annealing in an atmosphere containing hydrogen.

**105.** The method according to any one of claims 71 to 104, characterized by further comprising the step of, after the bonded substrate stack is completely separated, removing the cavity-containing layer remaining on the first substrate to allow reuse of the substrate.

**106.** A substrate characterized in that the substrate is obtained by forming a first substrate (1501 - 1504) having a cavity-containing layer (1502) with a number of cavities and, on the cavity-containing layer, a non-cavity-containing layer (1503, 1504), bonding the first substrate (1501 - 1504) and an independently prepared second substrate (1505) via the non-cavity-containing layer (1503, 1504) to form a bonded substrate stack, storing the bonded substrate stack in a closed vessel (1201) and setting an internal space of said closed vessel (1201) at a high pressure to break cavity walls in the cavity-containing layer (1502) and separate at least part of the bonded substrate stack at the cavity-containing layer (1502).

# FIG. 1A

# FIG. 1B

# FIG. 1C

# FIG. 1D

# FIG. 1E

# FIG. 2

106

EP 0 989 593 A2

# FIG. 3

EP 0 989 593 A2

F I G. 4

F I G. 5

FIG. 6

EP 0 989 593 A2

F I G. 7

EP 0 989 593 A2

# F I G. 8

FIG. 9

EP 0 989 593 A2

EP 0 989 593 A2

# FIG. 10

1100

F I G. 11

EP 0 989 593 A2

F I G. 12

EP 0 989 593 A2

F I G. 13

EP 0 989 593 A2

EP 0 989 593 A2

FIG. 15

F I G.  16

EP 0 989 593 A2

F I G. 17

EP 0 989 593 A2

F I G. 18

EP 0 989 593 A2

## F I G. 19A

1501

## F I G. 19B

1504
1503
1502

1501

## F I G. 19C

1505

1504
1503
1502

1501

## F I G. 19D

1501

1502

1503
1504

1505

## F I G. 19E

1501

1503
1504

1505

# F I G. 20

EP 0 989 593 A2